(19) Europäisches Patentamt / European Patent Office / Office européen des brevets

(11) **EP 4 474 947 B1**

(12) **EUROPEAN PATENT SPECIFICATION**

(45) Date of publication and mention
of the grant of the patent:
**28.01.2026   Bulletin 2026/05**

(21) Application number: **23880914.9**

(22) Date of filing: **06.12.2023**

(51) International Patent Classification (IPC):
***G06F 1/20*** *(2006.01)*

(52) Cooperative Patent Classification (CPC):
**G06F 1/20;** Y02D 10/00

(86) International application number:
**PCT/CN2023/136640**

(87) International publication number:
**WO 2024/216998 (24.10.2024 Gazette 2024/43)**

(54) **COOLING SYSTEM AND ELECTRONIC DEVICE**

KÜHLSYSTEM UND ELEKTRONISCHE VORRICHTUNG

SYSTÈME DE REFROIDISSEMENT ET DISPOSITIF ÉLECTRONIQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority:   **21.04.2023   CN 202310429372**

(43) Date of publication of application:
**11.12.2024   Bulletin 2024/50**

(73) Proprietor: **Honor Device Co., Ltd.
Shenzhen, Guangdong 518040 (CN)**

(72) Inventors:
  • **CHEN, Jinyu
    Shenzhen, Guangdong 518040 (CN)**
  • **SUN, Guiping
    Shenzhen, Guangdong 518040 (CN)**
  • **ZHANG, Lukuan
    Shenzhen, Guangdong 518040 (CN)**

(74) Representative: **Epping - Hermann - Fischer
Patentanwaltsgesellschaft mbH
Schloßschmidstraße 5
80639 München (DE)**

(56) References cited:
CN-A- 112 486 291        CN-A- 114 096 122
CN-A- 116 185 155        CN-U- 209 343 279
US-A1- 2012 293 958      US-A1- 2023 069 684

**Description**

This application claims priority to Chinese Patent Application No. 202310429372.5, filed with the China National Intellectual Property Administration on April 21, 2023 and entitled "HEAT DISSIPATION SYSTEM AND ELECTRONIC DEVICE", which is cited herein as a reference in its entirety.

**TECHNICAL FIELD**

Embodiments of this application relate to the field of heat dissipation technologies, and in particular, to a heat dissipation system and an electronic device.

**BACKGROUND**

A computer is a machine that has a high-speed computing capability, and includes various types such as a personal computer or an embedded computer. The personal computer is a multi-purpose computer that is suitable for personal use in terms of a size, a price, and performance. For example, a desktop computer, a notebook computer, and a tablet computer are personal computers. With development of integration technologies, the computer is equipped with many highly integrated semiconductor chips, for example, a central processing unit (central processing unit, CPU), a graphics processing unit (graphics processing unit, GPU), and a graphics double data rate (graphics double data rate, GDDR). Due to a limitation imposed by a working principle of the semiconductor chip, in a running process of the computer, components such as the CPU generate a large amount of heat. In addition, the computer further includes some other components that are prone to generate heat, for example, a capacitor, a MOS transistor, and an inductor coil. A heating phenomenon of some high-performance personal computers is more obvious. Therefore, to ensure stable running of the personal computer, a reliable heat dissipation solution needs to be configured for the personal computer.

In a heat dissipation solution for the computer, a thermally conductive component and a fan are usually configured for the computer. The thermally conductive component includes a heat pipe. The heat pipe is configured to transfer heat generated by a heat generation chip or component to a position of the fan. The fan can drive air around the fan to flow, and dissipate the heat to an external environment through the flowing air, to cool the chip or the component.

However, due to a limitation imposed by heat transfer efficiency of the thermally conductive component, the heat generated by the chip or the component is prone to be accumulated in the thermally conductive component, and often cannot be dissipated to the external environment in a timely manner. This causes a temperature of the chip or the component to be excessively high, and affects performance of the chip or the component. Consequently, overall performance of the computer is degraded, and user experience is affected.

US 2023/069684 A1 relates to an electronic apparatus comprising a chassis; first and second heating elements in the chassis; and a cooling module in the chassis, the cooling module absorbing heat generated from the first and second heating elements, the cooling module comprising: a first vapor chamber connected to the first heating element and including two first metal plates defining a first closed space therebetween to contain a first working fluid in the first closed space; and a second vapor chamber connected to the second heating element and including two second metal plates defining a second closed space therebetween to contain a second working fluid in the second closed space; the first and second vapor chambers being side-by-side to each other with a step therebetween, the first vapor chamber having a bridge that is a part of at least one of the two first metal plates, the bridge straddling the step and extending toward to a surface of the second vapor chamber, the bridge being outside of the first and second closed spaces.

US 2012/293958 A1 relates to a heat dissipating apparatus comprising a centrifugal fan comprising a frame defining an air outlet, and an elastic plate extending outwards from the frame; a heat sink adjacent to the air outlet of the centrifugal fan; and a heat pipe comprising an evaporation section for absorbing heat from a heat generating component and a condensation section connected to the heat sink, the elastic plate abutting the evaporation section of the heat pipe and applying a force on the evaporation section toward the heat generating component.

**SUMMARY**

Embodiments of the invention provide a heat dissipation system and an electronic device, to resolve a problem that a heat dissipation effect in a conventional heat dissipation solution is poor. According to claim 1, an embodiment of the invention provides a heat dissipation system, including: a thermally conductive assembly, wherein the thermally conductive assembly includes a thermally conductive plate that covers a surface of a heat source; a cooling fan, where an air outlet of the cooling fan faces the thermally conductive assembly; and a bridge, where a first end of the bridge is connected to a housing of the cooling fan, and a second end of the bridge is connected to the thermally conductive plate. Both the housing of the cooling fan and the bridge are made of metal materials.

In this way, the bridge may transfer heat between the thermally conductive assembly and the housing of the cooling fan, so that heat on the thermally conductive assembly is quickly dissipated to an external environment, to improve heat exchange efficiency between the thermally conductive assembly and the external environment, alleviate a problem of heat accumulation on the thermally conductive assembly, improve utilization of a cold air flow formed by the cooling fan, and improve efficiency of heat dissipation for the heat source. The thermally conductive assembly further includes a first heat pipe; the first heat pipe is bonded to the thermally conductive plate; one end of the first heat pipe is located between the thermally conductive plate and the bridge. In this way, thermal resistance between the bridge and each of the thermally conductive plate and the first heat pipe may be reduced, to improve heat transfer efficiency.

In an implementable manner, a thermally conductive medium is filled between the thermally conductive plate and the heat source; the cooling fan is disposed adjacent to the thermally conductive plate; and the first end of the bridge is connected to the housing of the cooling fan, and the second end of the bridge laps over the thermally conductive plate. In this way, heat on the thermally conductive plate may be transferred to the housing of the cooling fan through the bridge, and then may be dissipated to the external environment by using a cold air flow.

In an implementable manner, the thermally conductive assembly further includes a first thermally conductive pad; the first thermally conductive pad is crimped between the bridge and each of the thermally conductive plate and the first heat pipe. In this way, thermal resistance between the bridge and each of the thermally conductive plate and the first heat pipe may be reduced, to improve heat transfer efficiency.

In an implementable manner, the thermally conductive plate includes a first flat plate and a second flat plate that are connected to each other; both the first flat plate and the second flat plate cover the surface of the heat source, and the thermally conductive medium is filled between the heat source and each of the first flat plate and the second flat plate; there is a height difference between the first flat plate and the second flat plate; and the first heat pipe is located on a side surface that is of the first flat plate and that is far away from the heat source, and a side surface that is of the first heat pipe and that is far away from the heat pipe and a side surface that is of the second flat plate and that is far away from the heat source are on a same plane. This facilitates layout of heat sources with different thicknesses, and may improve flatness of a component, to improve heat transfer efficiency between the bridge and the thermally conductive plate.

In an implementable manner, the thermally conductive assembly further includes: at least one second heat pipe that is bonded to the thermally conductive plate, where the second heat pipe extends outward from the thermally conductive plate in at least one direction, to form at least one condensing portion far away from the heat source; and a fin that is distributed in each condensing portion and that is connected to a pipe wall of the condensing portion; and there is at least one cooling fan, the at least one cooling fan is disposed in a one-to-one correspondence with the at least one condensing portion, and an air outlet of each cooling fan faces a condensing portion corresponding to the cooling fan, and faces a fin connected to the condensing portion corresponding to the cooling fan. In this way, the heat on the thermally conductive plate may be dissipated to the external environment through the second heat pipe and the fin.

In an implementable manner, when there are a plurality of second heat pipes, the plurality of second heat pipes are disposed in parallel on the thermally conductive plate. The plurality of second heat pipes are disposed, to improve heat exchange efficiency between the thermally conductive plate and the external environment, and avoid excessive heat accumulation on the thermally conductive plate, so as to avoid impact on efficiency of heat dissipation for the heat source.

In an implementable manner, the thermally conductive assembly further includes a second thermally conductive pad, and the second thermally conductive pad is crimped between the thermally conductive plate and the heat source; and/or the thermally conductive assembly further includes thermally conductive silicone, and the thermally conductive silicone is filled between the thermally conductive plate and the heat source. In this way, thermal resistance between the thermally conductive plate and the heat source may be reduced, to improve heat transfer efficiency between the thermally conductive plate and the heat source.

In an implementable manner, the thermally conductive assembly further includes an elastic sheet; and one end of the elastic sheet is fastened to the thermally conductive plate, and the other end is fastened to a printed circuit board on which the heat source is located, to press the thermally conductive plate onto the heat source. In this way, a distance between the thermally conductive plate and the heat source may be shortened, so that the thermally conductive plate is tightly pressed onto the heat source, to reduce thermal resistance between the thermally conductive plate and the heat source.

In an implementable manner, the housing of the cooling fan abuts against a heat receiving part, and heat on the heat receiving part is transferred by the heat source. In this way, heat dissipation may be performed for the heat receiving part by using the housing of the cooling fan.

In an implementable manner, the thermally conductive assembly further includes a third thermally conductive pad, and the third thermally conductive pad is crimped between the cooling fan and the heat receiving part. In this way, thermal resistance between the cooling fan and the heat receiving part may be reduced, to improve heat transfer efficiency between the cooling fan and the heat receiving part.

In an implementable manner, the bridge and the cooling fan are of an integral structure. In this way, thermal resistance between the bridge and the cooling fan may be reduced, to improve heat transfer efficiency between the bridge and the cooling fan.

According to claim 14, an embodiment of the invention provides an electronic device, including the heat dissipation system of claim 1 and the implementations.

It may be learned from the foregoing technical solutions that the embodiments of the invention provide the heat dissipation system and the electronic device. In the heat dissipation system, heat on the thermally conductive assembly is diffused into air by using a cold air flow generated by the cooling fan, and some heat on the thermally conductive assembly is further transferred to the housing of the cooling fan through the bridge, to increase a heat exchange path between the thermally conductive assembly and the outside, increase a speed of heat exchange between the thermally conductive assembly and the outside, and improve utilization of the cold air flow. Therefore, heat dissipation efficiency of the heat dissipation system is higher.

## BRIEF DESCRIPTION OF DRAWINGS

FIG. 1 is a schematic diagram of a structure of a heat dissipation system;
FIG. 2 is an overall schematic diagram of a heat dissipation system according to an embodiment of this application;
FIG. 3 is a schematic diagram of a direction A in FIG. 2;
FIG. 4 is a schematic exploded view of the heat dissipation system shown in FIG. 2;
FIG. 5 is a diagram of a position relationship between a bridge, a thermally conductive plate, and a first heat pipe according to an embodiment of this application;
FIG. 6 is a schematic diagram of a direction B in FIG. 2;
FIG. 7 is a schematic exploded view of another heat dissipation system according to an embodiment of this application;
FIG. 8 is a schematic diagram of heat transfer in the heat dissipation system shown in FIG. 7;
FIG. 9 is a diagram of a position relationship between a second bridge, a second thermally conductive plate, and a first heat pipe according to an embodiment of this application;
FIG. 10 is a schematic exploded view of a notebook computer that includes a heat dissipation system according to an embodiment of this application;
FIG. 11 is a partially enlarged view of FIG. 10; and
FIG. 12 is a schematic diagram of a position of a third thermally conductive pad according to an embodiment of this application.

01: Heat generation component; 02: Copper plate; 03: Thermally conductive pipe; 04: Heat dissipation fin; 05: Fan; 10: Rear screen cover; 20: Front screen frame; 30: Upper host cover; 40: Lower host cover; 51: Host board; 511: Accommodation hole; 52: CPU; 53: GPU; 54: GDDR; 55: CPU VR; 56: GPU VR; 57: Charge; 100: Thermally conductive assembly; 101: Thermally conductive plate; 1011: First flat plate; 1012: Second flat plate; 1014: First thermally conductive plate; 1015: Second thermally conductive plate; 102: First heat pipe; 103: First thermally conductive pad; 104, 104A, and 104B: Second heat pipe; 1041: Condensing portion; 10411, 10411A, and 10411B: First condensing portion; 10412, 10412A, and 10412B: Second condensing portion; 105: Fin; 1051: First fin; 1052: Second fin; 106: Second thermally conductive pad; 107: Thermally conductive silicone; 108: Elastic sheet; 109: Third thermally conductive pad; 200: Heat source; 300: Cooling fan; 301: Air inlet; 302: First cooling fan; 3021: First screw seat; 303: Second cooling fan; 3031: Second screw seat; 400: Bridge; 401: First bridge; 402: Second bridge; and 500: Heat receiving part.

## DESCRIPTION OF EMBODIMENTS

The following clearly describes the technical solutions in the embodiments of this application with reference to the accompanying drawings in the embodiments of this application.

In the descriptions of this application, unless otherwise specified, "/" means "or". For example, A/B may represent A or B. In this specification, "and/or" is merely an association relationship for describing associated objects, and represents that three relationships may exist. For example, A and/or B may represent the following three cases: Only A exists, both A and B exist, and only B exists. In addition, "at least one" means one or more, and "a plurality of" means two or more. The words such as "first" and "second" do not limit a quantity or an execution sequence, and the words such as "first" and "second" do not indicate a definite difference.

It should be noted that in this application, the word such as "example" or "for example" is used to represent giving an example, an illustration, or a description. Any embodiment or design solution described as "example" or "for example" in this application should not be construed as being preferred or advantageous over other embodiments or design solutions. Exactly, the words such as "example" or "for example" are used to present related concepts in a specific manner.

The following first describes an application scenario of the embodiments of this application with reference to the accompanying drawings.

A computer is a machine that has a high-speed computing capability, and includes various types such as a personal computer or an embedded computer. The personal computer is a multi-purpose computer that is suitable for personal use in terms of a size, a price, and performance. For example, a desktop computer, a notebook computer, and a tablet computer are personal computers. With development of integration technologies, the computer is equipped with many highly integrated semiconductor chips, for example, a central processing unit (central processing unit, CPU), a graphics processing unit (graphics processing unit, GPU), and a graphics double data rate (graphics double data rate, GDDR). Due to a limitation imposed by a working principle of the semiconductor chip, in a running process of the computer, components such as the CPU generate a large amount of heat. In addition, the computer further includes some other components that are prone to generate heat, for example, a capacitor, a MOS transistor, and an inductor coil. A heating phenomenon of some high-performance personal computers is more obvious. Therefore, to ensure stable running of the personal computer, a reliable heat dissipation solution needs to be configured for the personal computer.

In a heat dissipation solution for the computer, a thermally conductive component and a fan are usually configured for the computer. The thermally conductive component includes a heat pipe. The heat pipe is configured to transfer heat generated by a heat generation chip or component to a position of the fan. The fan can drive air around the fan to flow, and dissipate the heat to an external environment through the flowing air, to cool the chip or the component.

However, due to a limitation imposed by heat transfer efficiency of the thermally conductive component, the heat generated by the chip or the component is prone to be accumulated in the thermally conductive component, and cannot be dissipated to the external environment in a timely manner. This causes a temperature of the chip or the component to be excessively high, and affects performance of the chip or the component. Consequently, overall performance of the computer is degraded, and user experience is affected.

With reference to the accompanying drawings, the following describes a heat dissipation solution by using an example.

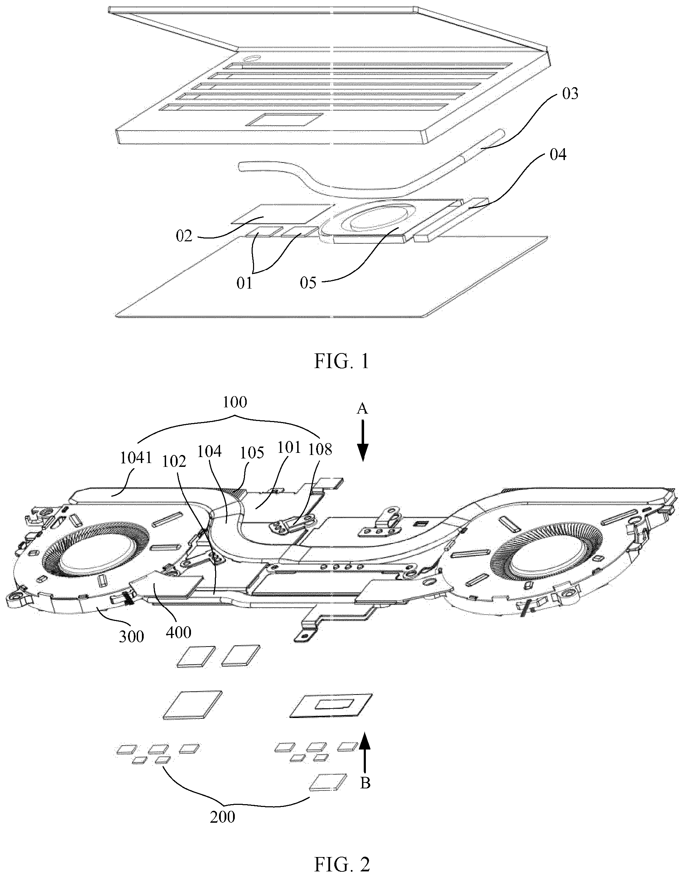

FIG. 1 is a schematic diagram of a structure of a heat dissipation system.

As shown in FIG. 1, the heat dissipation system may be applied to a notebook computer. The heat dissipation system includes a heat generation component 01, a copper plate 02, a thermally conductive pipe 03, a heat dissipation fin 04, and a fan 05. The copper plate 02 covers the heat generation component 01. One end of the thermally conductive pipe 03 is fastened to the copper plate 02, and the other end extends in a direction far away from the heat generation component 01.

The heat dissipation fin 04 abuts against an end that is of the thermally conductive pipe 03 and that is far away from the heat generation component 01. The fan 05 includes an air outlet, and the air outlet faces the heat dissipation fin 04.

Further, metallic copper is a material with a relatively high coefficient of thermal conductivity. Therefore, when the copper plate 02 made of the metallic copper covers the heat generation component 01, the copper plate 02 may collect heat generated by the heat generation component 01. Further, the thermally conductive pipe 03 is a heat transfer element that implements heat transfer based on a phase change of working liquid inside the thermally conductive pipe 03, and may absorb heat from an end with a relatively high temperature, and then transfer the heat to an end with a relatively low temperature. Specifically, the thermally conductive pipe 03 may absorb heat from the copper plate 02, and transfer the heat to the heat dissipation fin 04. Further, the air outlet of the fan 05 faces the heat dissipation fin 04, and the heat on the heat dissipation fin 04 may be taken away in a manner in which the air outlet directly blows the heat dissipation fin 04. In this way, the heat generated by the heat generation component 01 may be dissipated to an external environment.

However, there is thermal resistance between the copper plate 02 and the thermally conductive pipe 03, and the thermal resistance affects heat transfer efficiency between the copper plate 02 and the thermally conductive pipe 03. Consequently, the thermally conductive pipe 03 absorbs a relatively small amount of heat from the copper plate 02. Finally, the heat generated by the heat generation component 01 is continuously accumulated on the copper plate 02 and is difficult to dissipate, and a heat dissipation effect of the heat dissipation system for the heat generation component 01 is affected. In this case, a problem that a temperature of the heat generation component 01 rises abnormally is prone to occur, or frequency reduction of the heat generation component 01 is prone to occur, and user experience is affected.

To resolve the foregoing problem, the embodiments of this application provide a heat dissipation system. In the heat dissipation system, a characteristic of a temperature difference between a cooling fan and a thermally conductive assembly may be fully used, so that a housing of the cooling fan participates in a heat dissipation process, to further improve heat dissipation efficiency of the heat dissipation system for a heat generation component, and improve user experience. The heat dissipation system provided in the embodiments of this application may be applied to an electronic device with a heat dissipation requirement, for example, a desktop computer, a notebook computer, a small notebook computer, a tablet computer, and an ultrabook, and may be further applied to devices such as a workstation device, a server, a switch, a network node device, a large screen device (for example, a smart screen and a smart television), a handheld game console, a home game console, a virtual reality device, an augmented reality device, a hybrid reality device, and a vehicle-mounted intelligent terminal.

The heat dissipation system provided in the embodiments of this application is described below in detail with reference to the accompanying drawings.

FIG. 2 is an overall schematic diagram of a heat dissipation system according to an embodiment of this application.

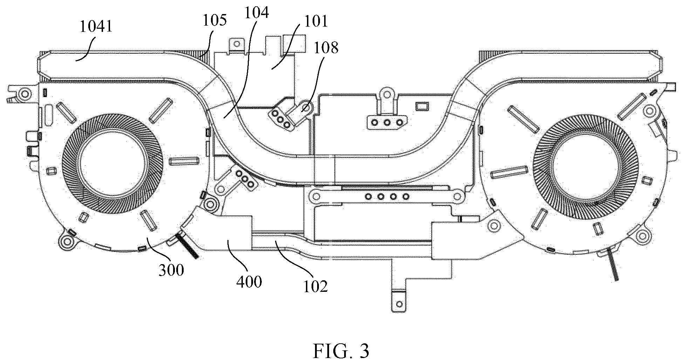

FIG. 3 is a schematic diagram of a direction A in FIG. 2.

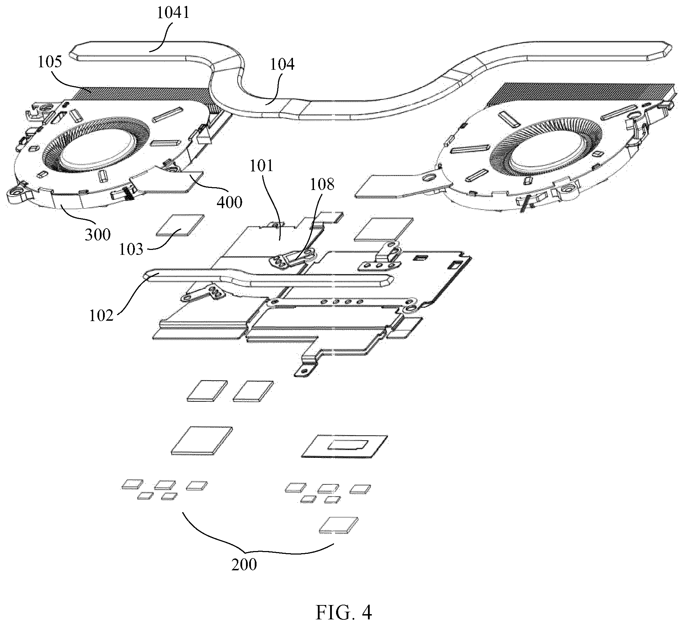

FIG. 4 is a schematic exploded view of the heat dissipation system shown in FIG. 2.

As shown in FIG. 2-FIG. 4, the heat dissipation system provided in this embodiment of this application may be applied to an electronic device, and is configured to dissipate heat for various heat sources, for example, a heat source 200, of the electronic device. There may be a plurality of heat sources 200. The heat source 200 may be a CPU, a GPU, or a GDDR of the electronic device, may be a capacitor, a MOS transistor, an inductor coil, or the like configured for a CPU or a GPU, or may be any component that generates heat when the electronic device is charged or the like. In this embodiment of this application, the heat dissipation system includes a thermally conductive assembly 100, a cooling fan 300, and a bridge 400. The thermally conductive assembly 100 covers a surface of the heat source 200, and a thermally conductive medium may be filled between the thermally conductive assembly 100 and the heat source 200. The thermally conductive medium may be, for example, thermally conductive silicone or a thermally conductive pad. In this way, the thermally conductive assembly 100 may be configured to collect heat generated when the heat source 200 works, and transfer, in a direction far away from the heat source 200, the heat collected by the thermally conductive assembly 100. The cooling fan 300 abuts against a part that is of the thermally conductive assembly 100 and that is far away from the heat source 200, and an air outlet of the cooling fan 300 faces the thermally conductive assembly 100.

The cooling fan 300 may be, for example, a centrifugal fan. An air inlet and an air outlet may be disposed on a housing of the cooling fan 300. The cooling fan 300 includes parts such as an impeller and a rotating shaft. The impeller forms a flow path communicating with the air inlet and the air outlet. As the cooling fan 300 rotates, an air flow may axially flow into the flow path from the outside of the electronic device through the air inlet, be thrown to an edge of the impeller under action of centrifugal force, then be discharged from the air outlet, and finally be blown on the thermally conductive assembly 100. The air flow flows on the thermally conductive assembly 100, and may blow heat on the thermally conductive assembly 100 to the outside of the electronic device. In this way, the heat generated by the heat source 200 may be dissipated to an external environment, to implement heat dissipation for the heat source 200.

Still referring to FIG. 2-FIG. 4, a first end of the bridge 400 may be connected to the housing of the cooling fan 300, and a second end of the bridge 400 may lap over the thermally conductive assembly 100. In this embodiment of this application, the bridge 400 may be of a plate structure made of a material with an excellent heat-conducting property, and the bridge 400 is disposed between the housing of the cooling fan 300 and the thermally conductive assembly 100, to perform heat transfer between the cooling fan 300 and the thermally conductive assembly 100.

The following further describes a heat transfer process of the bridge 400 in detail.

In this embodiment of this application, the cooling fan 300 is a component communicating with the outside and the inside of the electronic device, and an air flow flowing inside the housing of the cooling fan 300 flows into the housing from the external environment through the air inlet on the housing. The electronic device includes the heat source 200 that generates heat, and the like. Therefore, a temperature of the external environment is significantly lower than an internal temperature of the electronic device, and the air flow entering the housing of the cooling fan 300 from the outside is a cold air flow with a relatively low temperature relative to the thermally conductive assembly 100. Further, the cold air flow continuously flows, so that there is a significant temperature difference between the housing of the cooling fan 300 and the thermally conductive assembly 100. In actual application, a temperature of the thermally conductive assembly 100 is approximately 60°C, and a temperature of the housing of the cooling fan 300 is lower than 40°C because the housing is affected by the cold air flow. It may be learned that there is a significant temperature difference between the thermally conductive assembly 100 and the housing of the cooling fan 300. In some cases, the temperature difference may reach 30°C.

The bridge 400 provided in this embodiment of this application may lap between the housing of the cooling fan 300 and the thermally conductive assembly 100. In this way, heat may flow from a high-temperature region in which the thermally conductive assembly 100 is located to a low-temperature region in which the cooling fan 300 is located. Further, after the heat on the thermally conductive assembly 100 is transferred to the housing of the cooling fan 300 with a relatively low temperature, as the cold air flow flows inside the cooling fan 300, the heat on the housing of the cooling fan 300 may be gradually dissipated to the external environment with the cold air flow, to reduce the temperature of the thermally conductive assembly 100.

It may be learned that in this embodiment of this application, two heat dissipation paths are provided for the thermally conductive assembly 100. A first heat dissipation path is a manner in which the cooling fan 300 directly blows, and the heat on the thermally conductive assembly 100 is directly taken away by using the cold air flow. A second heat dissipation path is a new path provided by the bridge 400. The bridge 400 may transfer the heat on the thermally conductive assembly 100 to the housing of the cooling fan 300 with a relatively low temperature, and then the heat on the housing of the cooling fan 300 can be dissipated to the external environment through flow of the cold air flow, to reduce the temperature of the thermally conductive assembly 100.

In this way, heat exchange efficiency between the thermally conductive assembly 100 and the external environment is improved, to alleviate a problem of heat accumulation on the thermally conductive assembly 100, and improve utilization of the cold air flow. Further, heat exchange efficiency between the thermally conductive assembly 100 and the heat source 200 is improved, and efficiency of heat dissipation for the heat source 200 is improved, to avoid abnormal heat generation or frequency reduction of the heat source 200 that is caused due to a poor heat dissipation effect.

In this embodiment of this application, with continuous heat transfer between the housing of the cooling fan 300 and the thermally conductive assembly 100, the temperature of the housing of the cooling fan 300 rises slightly, and the temperature of the thermally conductive assembly 100 is not excessively high. In this way, even temperature distribution is implemented between the thermally conductive assembly 100 and the housing of the cooling fan 300, so that local temperature overheating of the electronic device can be avoided, to improve user experience.

In this embodiment of this application, the housing of the cooling fan 300 and the bridge 400 may be made of metal materials, for example, may be made of aluminum alloy or copper. Thermal conductivity of the metal material is relatively high. For example, a coefficient of thermal conductivity of the aluminum alloy is approximately 236 W/(m*k). Therefore, the cooling fan 300 and the bridge 400 that are made of the metal materials can relatively quickly take away the heat on the thermally conductive assembly 100, and perform excellently in a heat transfer process. In addition, a specific heat capacity of the metal material is relatively large, and in particular, a specific heat capacity of the aluminum alloy material may reach 902 J/(kg.K). Therefore, the cooling fan 300 and the bridge 400 that are made of the metal materials have a stronger heat absorption or heat dissipation capability, to improve efficiency of heat exchange with the thermally conductive assembly 100.

In some embodiments, the cooling fan 300 and the bridge 400 may be of an integral structure. In this way, thermal resistance between the bridge 400 and the housing of the cooling fan 300 may be reduced, so that heat can be smoothly transferred from the bridge 400 to the housing of the cooling fan 300. The cooling fan 300 and the bridge 400 may be manufactured by using a die casting process. When the cooling fan 300 is manufactured, the bridge 400 may be directly integrally formed on the housing of the cooling fan 300.

Still referring to FIG. 4, the thermally conductive assembly 100 provided in this embodiment of this application may include a thermally conductive plate 101. The thermally conductive plate 101 covers the surface of the heat source 200, and the thermally conductive medium is filled between the thermally conductive plate 101 and the heat source 200. In this way, the thermally conductive plate 101 may absorb heat from the heat source 200, and the heat generated when the heat source 200 works may be transferred to the thermally conductive plate 101. Further, the cooling fan 300 is disposed adjacent to the thermally conductive plate 101, the first end of the bridge 400 is connected to the housing of the cooling fan 300, and the second end of the bridge 400 laps over the thermally conductive plate 101.

In this embodiment of this application, the bridge 400 may transfer heat on the thermally conductive plate 101 to the housing of the cooling fan 300. When the cooling fan 300 rotates, a cold air flow may be formed. The cold air flow specifically enters the cooling fan 300 from the external environment, and then the cold air flow may flow from the air outlet of the cooling fan 300 to the external environment. Therefore, as the cold air flow flows, the heat on the housing of the cooling fan 300 may be dissipated to the external environment. In this way, the heat on the thermally conductive plate 101 may be quickly dissipated to the external environment.

It should be additionally noted that the air outlet of the cooling fan 300 does not face the thermally conductive plate 101. A specific direction of the air outlet of the cooling fan 300 may be determined based on an actual layout status. This is not specifically limited in this embodiment of this application. A specific position relationship between the cooling fan 300 and the thermally conductive plate 101, for example, a distance between the cooling fan 300 and the thermally conductive plate 101, may also be determined based on an actual layout status. This is not specifically limited in this embodiment of this application.

In some implementations, a material of the thermally conductive plate 101 may be metallic copper. A coefficient of thermal conductivity of the metallic copper is relatively high, and is approximately equal to 401 W/(m·K). Therefore, the thermally conductive plate 101 made of the metallic copper has a high heat-conducting property, and can relatively quickly absorb heat of the heat source 200. Still referring to FIG. 4, the thermally conductive assembly 100 may further include a first heat pipe 102 and a first thermally conductive pad 103. The first heat pipe 102 is bonded to the thermally conductive plate 101, one end of the first heat pipe 102 is located between the thermally conductive plate 101 and the bridge 400, and the first thermally conductive pad 103 may be crimped between the bridge 400 and each of the thermally conductive plate 101 and the first heat pipe 102.

It may be understood that the bridge 400 may lap over both the thermally conductive plate 101 and the first heat pipe 102. A position relationship between the bridge 400, the thermally conductive plate 101, and the first heat pipe 102 is described below in detail. Details are not described herein.

The heat pipe is a heat transfer element that implements heat transfer based on a phase change of working liquid inside the heat pipe, and has an excellent heat-conducting property. In actual application, the heat pipe may be laid on a heat source. In addition, the heat pipe may extend from a surface of the heat source in a direction far away from the heat source. In this way, a temperature difference may be formed on the entire heat pipe. Further, the heat pipe is filled with liquid. In an actual working process, a part that is of the heat pipe and that overlaps the heat source may absorb heat from the heat source. Heat absorption is specifically manifested in that the liquid inside the heat pipe is evaporated and vaporized by heat. Further, steam flows under a small pressure difference inside the heat pipe, and gradually flows to an end that has a relatively low temperature and that is of the heat pipe (an end far away from the heat source). The steam may be condensed into liquid herein to release heat. Then, the liquid may flow back to the part that is of the heat pipe and that overlaps the heat source, and the foregoing steps continue to be cyclically performed. It may be learned that the heat pipe may be used for heat transfer. Based on the working process of the heat pipe, the heat pipe may be divided into an evaporating portion and a condensing portion. It may be learned that the first heat pipe 102 has an excellent heat-conducting property. Therefore, the first heat pipe 102 may quickly transfer the heat on the thermally conductive plate 101 to the bridge 400, to improve heat transfer efficiency between the thermally conductive plate 101 and the bridge 400. Further, heat accumulated on the thermally conductive plate 101 may be quickly transferred to the housing of the cooling fan 300, and heat dissipation efficiency is high.

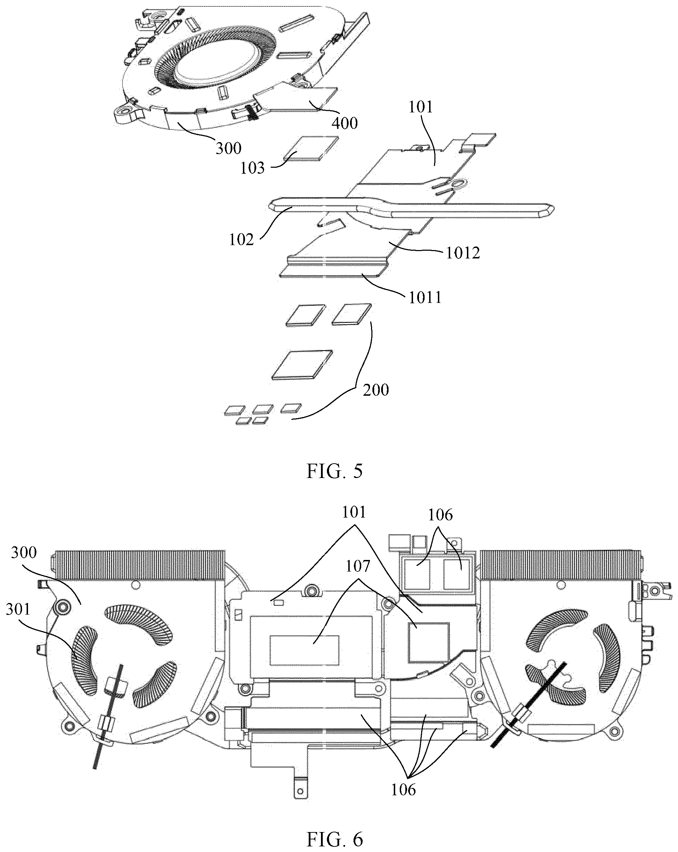

In this embodiment of this application, the first thermally conductive pad 103 may be, for example, silicone rubber, a glass fiber, or a polyester substrate. When being subjected to pressure, the first thermally conductive pad 103 may fill a gap between the thermally conductive plate 101 and the bridge 400 and a gap between the first heat pipe 102 and the bridge 400 as much as possible, and squeeze air out of a contact surface between the thermally conductive plate 101 and the bridge 400 and a contact surface between the first heat pipe 102 and the bridge 400. In this way, contact thermal resistance between contact surfaces may be reduced, to improve heat transfer efficiency. FIG. 5 is a diagram of a position relationship between the bridge, the thermally conductive plate, and the first heat pipe according to an embodiment of this application.

As shown in FIG. 5, the thermally conductive plate 101 may include a first flat plate 1011 and a second flat plate 1012 that are connected to each other. Both the first flat plate 1011 and the second flat plate 1012 cover the surface of the heat source 200. The thermally conductive medium may be filled between the heat source 200 and each of the first flat plate 1011 and the second flat plate 1012. The thermally conductive medium may be, for example, thermally conductive silicone or a thermally conductive pad. The first flat plate 1011 and the second flat plate 1012 may be of an integral structure, and there is a height difference between the first flat plate 1011 and the second flat plate 1012.

In a layout process of the electronic device, different heat sources 200 have different thicknesses. For example, the components such as the capacitor, the MOS transistor, or the inductor coil configured for the CPU or the GPU have different thicknesses. Further, because the heat source 200 is fastened to another component, for example, a host board, of the electronic device for working, flatness of a side surface that is of each heat source 200 and that is far away from the thermally conductive plate 101 needs to be ensured. Consequently, a side surface that is of the heat source 200 and that is close to the thermally conductive plate 101 is not flat enough.

There is a height difference between the first flat plate 1011 and the second flat plate 1012 provided in this embodiment of this application, so that the first flat plate 1011 and the second flat plate 1012 can tightly cover heat sources 200 with different thicknesses. In this way, heat dissipation may be smoothly implemented for the heat sources 200 with different thicknesses.

In actual application, a size of the first flat plate 1011 and a size of the second flat plate 1012 may be determined based on an actual layout status. This is not specifically limited in this embodiment of this application. In this embodiment of this application, the thermally conductive plate 101 is not limited to including only the first flat plate 1011 and the second flat plate 1012. The thermally conductive plate 101 may include a plurality of flat plate structures, and there may be a height difference between the plurality of flat plate structures. A specific structure of the thermally conductive plate 101 may be determined based on an actual layout status of the heat source 200. This is not specifically limited in this embodiment of this application.

It may be understood that in this embodiment of this application, the first flat plate 1011 is applicable to a heat source 200 with a relatively small thickness, and the second flat plate 1012 is applicable to a heat source 200 with a relatively large thickness. After the heat source 200 is covered, a distance between the first flat plate 1011 and the bridge 400 is greater than a distance between the second flat plate 1012 and the bridge 400, and a difference between the distances is the height difference between the first flat plate 1011 and the second flat plate 1012.

In this embodiment of this application, to increase a speed of heat transfer between the thermally conductive plate 101 and the housing of the cooling fan 300, a feasible manner is to increase a cross-sectional area of the bridge 400, to increase a contact area between the bridge 400 and the thermally conductive plate 101. The electronic device usually has a relatively small size, and layout of components inside the electronic device is relatively compact. Therefore, after the cross-sectional area of the bridge 400 is increased, an orthographic projection of the bridge 400 on the thermally conductive plate 101 may cover the first flat plate 1011 and the second flat plate 1012. In this case, the height difference between the first flat plate 1011 and the second flat plate 1012 affects lapping of the bridge 400. In this embodiment of this application, the first heat pipe 102 is used to compensate for the height difference. Specifically, the first heat pipe 102 is bonded to a side surface that is of the first flat plate 1011 and that is far away from the heat source 200, and a thickness of the first heat pipe 102 is equal to the height difference between the first flat plate 1011 and the second flat plate 1012. In this way, a side surface that is of the first heat pipe 102 and that is far away from the heat source 200 and the second flat plate 1012 may be on a same plane, and the bridge 400 may lap over both the second flat plate 1012 and the first heat pipe 102. This is equivalent to increasing a total contact area between the bridge 400 and the thermally conductive plate 101, and heat transfer between the bridge 400 and the thermally conductive plate 101 is performed by using the first heat pipe 102, so that a heat flux between the bridge 400 and the thermally conductive plate 101 can be increased, to improve heat transfer efficiency between the bridge 400 and the thermally conductive plate 101.

It should be additionally noted that, that the bridge 400 laps over both the first heat pipe 102 and the second flat plate 1012 is a position example of the bridge 400 provided in this embodiment of this application. The bridge 400 may alternatively lap over another position of the thermally conductive plate 101. For example, the bridge 400 may completely lap over the first heat pipe 102 without direct contact with the thermally conductive plate 101. A specific position relationship between the bridge 400, the first heat pipe 102, and the thermally conductive plate 101 may be determined based on an actual layout status. This is not specifically limited in this embodiment of this application.

It should be additionally noted that in this embodiment of this application, in a thickness direction of the heat source 200, the first end of the bridge 400 may be fastened to a side surface that is of the cooling fan 300 and that is far away from the heat source 200. The bridge 400 may also be fastened to a side surface of the cooling fan 300. A specific position to which the bridge 400 is fastened may be determined based on an actual situation, provided that it is ensured that the second end of the bridge 400 can lap over the thermally conductive plate 101.

In some implementations, a region in which the first heat pipe 102 is in contact with the first flat plate 1011 may be connected through welding. In this way, the first heat pipe 102 may be tightly bonded to the first flat plate 1011, to reduce thermal resistance between the first heat pipe 102 and the first flat plate 1011, and improve heat dissipation efficiency.

Still referring to FIG. 4 and FIG. 5, the second end of the bridge 400 may be close to an edge of the thermally conductive plate 101, and the first heat pipe 102 may be located on the edge of the thermally conductive plate 101. In addition, the edge of the thermally conductive plate 101 is far away from a second heat pipe 104. In this way, a position that is of the thermally conductive plate 101 and at which heat is transferred to the outside is dispersedly distributed on the thermally conductive plate 101, so that temperature distribution of the thermally conductive plate 101 can be more balanced, and local temperature overheating of the electronic device can be avoided, to improve user experience.

The first end of the bridge 400 is fastened to the housing of the cooling fan 300, and is fastened to a position close to the edge of the thermally conductive plate 101. In this way, a heat transfer distance between the thermally conductive plate 101 and the cooling fan 300 may be shortened, so that the heat can be quickly transferred from the thermally conductive plate 101 to the housing of the cooling fan 300, to avoid a case in which working performance of the heat source 200 is affected due to excessive heat accumulation on the thermally conductive plate 101.

In an actual layout process, an extension direction of the first heat pipe 102 on the thermally conductive plate 101 may follow a layout change of the heat source 200, and is not limited to a case in which the first heat pipe 102 is flush with the edge of the thermally conductive plate 101. A side edge that is of the thermally conductive plate 101 and that is far away from the second heat pipe 104 may protrude from the first heat pipe 102.

In some implementations, a quantity of first heat pipes 102 is not limited to one. One or more first heat pipes 102 may be disposed based on a layout status of the heat source 200, the cooling fan 300, and the bridge 400. This is not specifically limited in this embodiment of this application. Still referring to FIG. 3, in this embodiment of this application, the thermally conductive assembly 100 may further include at least one second heat pipe 104. The at least one second heat pipe 104 is bonded to the thermally conductive plate 101. In this way, the second heat pipe 104 may absorb the heat on the thermally conductive plate 101. Further, the second heat pipe 104 may extend outward from the thermally conductive plate 101 in at least one direction, to form at least one condensing portion 1041 far away from the heat source 200.

It may be understood that the second heat pipe 104 partially overlaps the thermally conductive plate 101, and the second heat pipe 104 may extend outward from the thermally conductive plate 101, to form the condensing portion 1041. Therefore, the second heat pipe 104 may absorb heat from the thermally conductive plate 101, and transfer the heat to the condensing portion 1041. In this way, the heat on the thermally conductive plate 101 may be transferred from the second heat pipe 104 to a position far away from the heat source 200, to implement heat dissipation for the heat source 200.

It should be noted that the at least one second heat pipe 104 may extend outward from the thermally conductive plate 101 in different directions, to form a plurality of condensing portions 1041 far away from the heat source 200. The plurality of condensing portions 1041 are equivalent to a plurality of parts that are of the thermally conductive assembly 100 and that are far away from the heat source 200. A specific extension direction of the second heat pipe 104 may be determined based on an actual heat dissipation requirement and a layout status. This is not specifically limited in this embodiment of this application.

FIG. 3 schematically shows that a middle position of the second heat pipe 104 overlaps the thermally conductive plate 101, and two ends respectively extend to two sides of the thermally conductive plate 101, to form one condensing portion 1041 on each of the two sides of the thermally conductive plate 101. This is merely an example case provided in this embodiment of this application, and the extension direction of the second heat pipe 104 is not specifically limited. It may be understood that inside the electronic device, the heat source 200 usually has a relatively small size and relatively compact layout, and the heat pipe cannot be in full contact with the heat source 200. If the heat pipe is directly bonded to the heat source 200, heat dissipation efficiency of the heat pipe for the heat source 200 is affected. In this embodiment of this application, the second heat pipe 104 is bonded to the thermally conductive plate 101, and the thermally conductive plate 101 is of a plate-like structure. In this way, the thermally conductive plate 101 may be in full contact with the heat source 200, and the thermally conductive plate 101 may fully absorb the heat generated by the heat source 200. This can not only improve heat dissipation efficiency of the heat dissipation system, but also improve utilization of the second heat pipe 104.

In some implementations, a region in which the second heat pipe 104 is in contact with the thermally conductive plate 101 may be connected through welding. In this way, the second heat pipe 104 may be tightly bonded to the thermally conductive plate 101, to reduce thermal resistance between the second heat pipe 104 and the thermally conductive plate 101, and improve heat dissipation efficiency.

Still referring to FIG. 3, the thermally conductive assembly 100 may further include a fin 105. The fin 105 is distributed in each condensing portion 1041, and is connected to a pipe wall of the condensing portion 1041. When steam inside the second heat pipe 104 flows to the condensing portion 1041, the steam is condensed into liquid to release heat. The fin 105 is connected to the pipe wall of the condensing portion 1041. Therefore, the fin 105 absorbs heat released by the condensing portion 1041.

In some implementations, a region in which the fin 105 is in contact with the condensing portion 1041 may be connected through welding. In this way, the condensing portion 1041 may be tightly bonded to the fin 105, to reduce thermal resistance between the condensing portion 1041 and the fin 105, and improve heat dissipation efficiency.

In this embodiment of this application, there is at least one cooling fan 300, the at least one cooling fan 300 is disposed in a one-to-one correspondence with the at least one condensing portion 1041, and an air outlet of each cooling fan 300 faces a condensing portion 1041 corresponding to the cooling fan 300, and faces a fin 105 connected to the condensing portion 1041 corresponding to the cooling fan 300. In some implementations, the air outlet of the cooling fan 300 may abut against the condensing portion 1041 and the fin 105.

It may be learned that there may be a one-to-one correspondence between the cooling fan 300 and the condensing portion 1041. Each time the second heat pipe 104 extends outward from the thermally conductive plate 101 in one direction, one condensing portion 1041 may be formed. The fin 105 is correspondingly disposed in each condensing portion 1041, and each condensing portion 1041 includes a cooling fan 300 corresponding to the condensing portion 1041. In this way, the cooling fan 300 may directly blow the fin 105 connected to the condensing portion 1041 corresponding to the cooling fan 300, and take away heat on the fin 105 by using a cold air flow. In addition, the cooling fan 300 may directly blow the condensing portion 1041 corresponding to the cooling fan 300. In this way, heat dissipation efficiency may be improved, and flatness between the second heat pipe 104 and the housing of the cooling fan 300 may be improved, to facilitate mounting.

In some implementations, a size of a contact area between the fin 105 and the cold air flow may be determined based on an actual layout status. This is not specifically limited in this embodiment of this application.

It should be noted that a specific direction or directions in which the second heat pipe 104 extends may be determined based on an actual situation. This is not specifically limited in this embodiment of this application.

It should be noted that the bridge 400 may be disposed between each cooling fan 300 and the thermally conductive plate 101, and a quantity of bridges 400 between each cooling fan 300 and the thermally conductive plate 101 is not limited to one. A specific quantity may be determined based on an actual situation.

It may be learned from the foregoing content that in this embodiment of this application, to transfer the heat on the thermally conductive plate 101 to the external environment, two paths are provided. In a first path, the second heat pipe 104 absorbs heat from the thermally conductive plate 101, and transfers the heat to the fin 105. Then, the cooling fan 300 may rotate and form a cold air flow to direct blow the fin 105, to dissipate the heat on the fin 105 to the external environment.

In a second path, the bridge 400 transfers the heat on the thermally conductive plate 101 to the housing of the cooling fan 300. Then, as the cold air flow flows inside the cooling fan 300, the cold air flow may dissipate the heat on the housing of the cooling fan 300 to the external environment through the fin 105.

It may be understood that there is a temperature difference between the cooling fan 300 and another component due to flow of the cold air flow. A low-temperature region is formed at a position of the cooling fan 300, and a position of the thermally conductive plate 101 is a high-temperature region relative to the low-temperature region. In this embodiment of this application, availability of the low-temperature region is considered. Therefore, the heat on the thermally conductive plate 101 is transferred to the housing of the cooling fan 300 by using the bridge 400. Then, the heat on the housing of the cooling fan 300 is dissipated to the external environment through the fin 105 by using the cold air flow. A new path for heat dissipation for the thermally conductive plate 101 is provided in this embodiment of this application.

It may be learned that in this embodiment of this application, a temperature difference between the low-temperature region and the high-temperature region is fully used, and heat in the high-temperature region is balanced and transferred to the low-temperature region, to increase a speed of dissipating the heat accumulated on the thermally conductive plate 101 to the external environment. Therefore, excessive heat accumulation on the thermally conductive plate 101 can be avoided, a problem that the heat source 200 cannot work normally due to a poor heat dissipation effect can be avoided, and heat dissipation efficiency is high.

FIG. 6 is a schematic diagram of a direction B in FIG. 2 (the heat source 200 is not shown).

As shown in FIG. 6, the thermally conductive medium may be a second thermally conductive pad 106, and the second thermally conductive pad 106 may be crimped between the thermally conductive plate 101 and the heat source 200. The second thermally conductive pad 106 may be, for example, silicone rubber, a glass fiber, or a polyester substrate. When being subjected to pressure, the second thermally conductive pad 106 may fill a gap between the thermally conductive plate 101 and the heat source 200 as much as possible, and squeeze air out of a contact surface between the thermally conductive plate 101 and the heat source 200. In this way, contact thermal resistance between contact surfaces may be reduced, to improve heat transfer efficiency.

The second thermally conductive pad 106 may be fastened to the thermally conductive plate 101. There may be a plurality of second thermally conductive pads 106, and the plurality of second thermally conductive pads 106 are respectively distributed at corresponding positions of the heat source 200 on the thermally conductive plate 101. A specific shape of the second thermally conductive pad 106 may depend on a shape of the heat source 200. This is not specifically limited in this embodiment of this application.

It should be noted that in FIG. 6, only some second thermally conductive pads 106 are shown as an example. A specific quantity of second thermally conductive pads 106 may be determined based on the actual layout status of the heat source 200. This is not specifically limited in this embodiment of this application. A specific distribution position of the second thermally conductive pad 106 may also be determined based on the actual layout status of the heat source 200. This is not specifically limited in this embodiment of this application.

Still referring to FIG. 6, the thermally conductive medium may be thermally conductive silicone 107, and the thermally conductive silicone 107 may be filled between the thermally conductive plate 101 and the heat source 200. The thermally conductive silicone 107 may be used to reduce thermal resistance between the thermally conductive plate 101 and the heat source 200, to improve heat transfer efficiency.

In some implementations, a component of the thermally conductive silicone 107 may be specifically zinc oxide ZnO, silver Ag, or the like. This is not specifically limited in this embodiment of this application.

In actual application, a specific distribution manner of the second thermally conductive pad 106 and the thermally conductive silicone 107 between the thermally conductive plate 101 and the heat source 200 may be determined based on an actual situation. This is not specifically limited in this embodiment of this application either.

Still referring to FIG. 6, an air inlet 301 may be disposed on the cooling fan 300. In this way, the cold air flow may enter the housing of the cooling fan 300 from the air inlet 301.

Still referring to FIG. 4, in this embodiment of this application, the thermally conductive assembly 100 may further include an elastic sheet 108. One end of the elastic sheet 108 may be fastened to the thermally conductive plate 101, and the other end may be fastened to a printed circuit board on which the heat source 200 is located, to press the thermally conductive plate 101 onto the heat source 200. When the heat dissipation system provided in this embodiment of this application is applied to an electronic device such as a notebook computer, the printed circuit board on which the heat source 200 is located may be a host board of the notebook computer. In this way, one end of the elastic sheet 108 may be fastened to the thermally conductive plate 101, and the other end may be fastened to the host board.

In actual application, the elastic sheet 108 may be in a stretched state. In this way, the elastic sheet 108 may exert force close to the printed circuit board on which the heat source 200 is located on the thermally conductive plate 101, so that the thermally conductive plate 101 is tightly pressed onto the printed circuit board. In this way, thermal resistance between the thermally conductive plate 101 and the heat source 200 may be reduced. In addition, the elastic sheet 108 may be used to ensure that the thermally conductive plate 101 is securely fastened to the printed circuit board on which the heat source 200 is located, to avoid movement of the thermally conductive plate 101. In this embodiment of this application, there may be a plurality of elastic sheets 108, and the plurality of elastic sheets 108 may be distributed at various positions of the thermally conductive plate 101. A specific distribution position may be determined based on an actual layout status. This is not specifically limited in this embodiment of this application.

In some implementations, when the heat dissipation system provided in this embodiment of this application is applied to the electronic device, the heat source 200 of the electronic device may transfer the heat generated by the heat source 200 to a component in direct contact or indirect contact with the heat source 200, and the heat dissipation system is in contact with the component, for example, the cooling fan 300 is in contact with the component. In the heat dissipation system provided in this embodiment of this application, a thermally conductive pad may be disposed at a position in which the cooling fan 300 is in contact with the component, to dissipate heat for the component through the housing of the cooling fan 300. A specific position at which the thermally conductive pad is specifically disposed and the like are described below in detail. Details are not described herein.

With reference to the accompanying drawings, a case in which the two ends of the second heat pipe 104 respectively extend to the two sides of the thermally conductive plate 101, to form one condensing portion 1041 on each of the two sides of the thermally conductive plate 101 is described below by using an example.

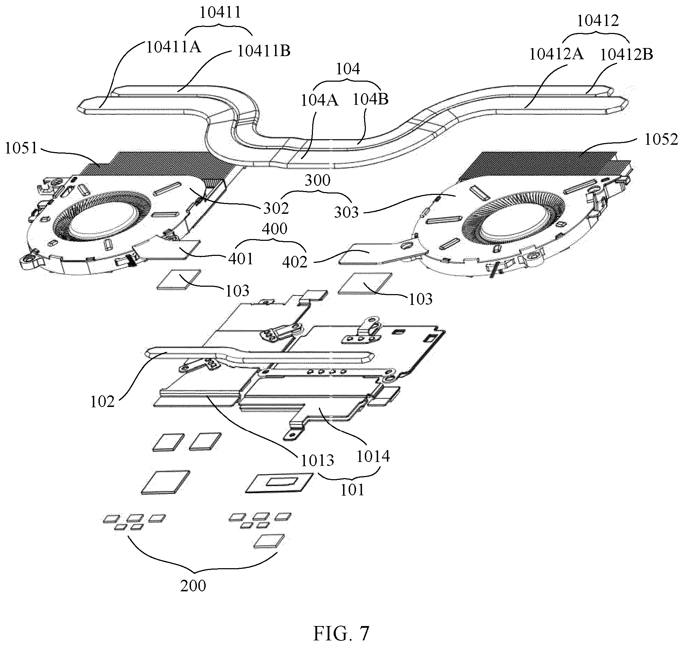

FIG. 7 is a schematic exploded view of another heat dissipation system according to an embodiment of this application.

As shown in FIG. 7, in this embodiment of this application, a thermally conductive assembly 100 may include a thermally conductive plate 101, a second heat pipe 104, a first fin 1051, and a second fin 1052. The thermally conductive plate 101 covers a surface of a heat source 200, and a thermally conductive medium may be filled between the thermally conductive plate 101 and the heat source 200. The thermally conductive medium may be, for example, a thermally conductive pad or thermally conductive silicone. In this way, the thermally conductive plate 101 may absorb heat from the heat source 200.

A second heat pipe 104 is bonded to the thermally conductive plate 101, and may be specifically bonded to a side surface that is of the thermally conductive plate 101 and that is far away from the heat source 200. In this way, the second heat pipe 104 may absorb heat from the thermally conductive plate 101. A middle position of the second heat pipe 104 partially overlaps the thermally conductive plate 101, and two ends of the second heat pipe 104 respectively extend to two sides of the thermally conductive plate 101, to form a first condensing portion 10411 and a second condensing portion 10412 that are far away from the heat source 200. The first condensing portion 10411 is distributed on one side of the thermally conductive plate 101, and the second condensing portion 10412 is distributed on the other side of the thermally conductive plate 101. In this way, the heat on the thermally conductive plate 101 may be transferred from the second heat pipe 104 to a position far away from the heat source 200, to implement heat dissipation for the heat source 200.

Still referring to FIG. 7, the first fin 1051 may be connected to a pipe wall of the first condensing portion 10411, and a specific connection manner may be welding. In this way, the second heat pipe 104 may transfer heat to the first fin 1051 through the first condensing portion 10411. The second fin 1052 may be connected to a pipe wall of the second condensing portion 10412, and a specific connection manner may be welding. In this way, the second heat pipe 104 may transfer heat to the second fin 1052 through the second condensing portion 10412. In this embodiment of this application, a size of a contact area between a cold air flow and each of the first fin 1051 and the second fin 1052 may be determined based on an actual layout status. This is not specifically limited in this embodiment of this application.

Still referring to FIG. 7, the heat dissipation system provided in this embodiment of this application may include a first cooling fan 302 and a second cooling fan 303. The first cooling fan 302 is disposed corresponding to the first condensing portion 10411, and an air outlet of the first cooling fan 302 faces the first condensing portion 10411 corresponding to the first cooling fan 302, and faces the first fin 1051 connected to the first condensing portion 10411 corresponding to the first cooling fan 302. In this way, when the first cooling fan 302 rotates, a cold air flow blowing to the first fin 1051 may be formed. When the cold air flow passes through the first fin 1051, heat on the first fin 1051 may be taken away.

The second cooling fan 303 is disposed corresponding to the second condensing portion 10412, and an air outlet of the second cooling fan 303 faces the second condensing portion 10412 corresponding to the second cooling fan 303, and faces the second fin 1052 connected to the second condensing portion 10412 corresponding to the second cooling fan 303. In this way, the second cooling fan 303 may form a cold air flow that directly blows the second fin 1052. When the cold air flow passes through the second fin 1052, heat on the second fin 1052 may be taken away.

In this way, the first fin 1051 and the second fin 1052 may continuously absorb heat from the second heat pipe 104, to ensure stable running of the heat dissipation system.

In this embodiment of this application, a side surface of the first fin 1051 may face the air outlet of the first cooling fan 302. A size of the first fin 1051 may match a size of the air outlet of the first cooling fan 302, so that the first fin 1051 is in full contact with a cold air flow blown out of the first cooling fan 302, to improve a heat dissipation effect. A side surface of the second fin 1052 may face the air outlet of the second cooling fan 303. A size of the second fin 1052 may match a size of the air outlet of the second cooling fan 303, so that the second fin 1052 is in full contact with a cold air flow blown out of the second cooling fan 303, to improve a heat dissipation effect. It should be additionally noted that the first condensing portion 10411 may cover a top of the first fin 1051, and a length of the first condensing portion 10411 may match a length of the first fin 1051. In this way, the first condensing portion 10411 may quickly transfer heat to the first fin 1051. The second condensing portion 10412 may cover a top of the second fin 1052, and a length of the second condensing portion 10412 may match a length of the second fin 1052. In this way, the second condensing portion 10412 may quickly transfer heat to the second fin 1052.

Still referring to FIG. 7, in this embodiment of this application, there may be a plurality of second heat pipes 104. When there are a plurality of second heat pipes 104, the plurality of second heat pipes 104 may be disposed in parallel on the thermally conductive plate 101, and directions in which the plurality of second heat pipes 104 extend outward from the thermally conductive plate 101 may be the same or different.

For example, still referring to FIG. 7, there may be two second heat pipes 104: a second heat pipe 104A and a second heat pipe 104B. The second heat pipe 104A and the second heat pipe 104B may be disposed in parallel on the thermally conductive plate 101, and directions in which the second heat pipe 104A and the second heat pipe 104B extend outward from the thermally conductive plate 101 are the same. In this case, the second heat pipe 104A and the second heat pipe 104B may form a heat pipe group.

Two ends of the second heat pipe 104A respectively extend to the two sides of the thermally conductive plate 101, to form a first condensing portion 10411A and a second condensing portion 10412A that are far away from the heat source 200. Two ends of the second heat pipe 104B respectively extend to the two sides of the thermally conductive plate 101, to form a first condensing portion 10411B and a second condensing portion 10412B that are far away from the heat source 200. The extension directions of the second heat pipe 104A and the second heat pipe 104B are the same. Therefore, the first condensing portion 10411A and the first condensing portion 10411B are disposed in parallel, and the first condensing portion 10411A and the first condensing portion 10411B may jointly correspond to the first cooling fan 302; and the second condensing portion 10412A and the second condensing portion 10412B are disposed in parallel, and the second condensing portion 10412A and the second condensing portion 10412B may jointly correspond to the second cooling fan 303. It may be learned that when extension directions of second heat pipes 104 in a heat pipe group are the same, condensing portions 1041 in a same extension direction may correspond to a same cooling fan 300.

It should be noted that when there are a plurality of second heat pipes 104, the sizes of the first fin 1051 and the second fin 1052 may be designed based on the quantity of second heat pipes 104.

The plurality of second heat pipes 104 are disposed, to improve heat exchange efficiency between the thermally conductive plate 101 and an external environment, and avoid excessive heat accumulation on the thermally conductive plate 101, so as to avoid impact on efficiency of heat dissipation for the heat source 200.

Still referring to FIG. 7, in this embodiment of this application, the thermally conductive plate 101 may include a first thermally conductive plate 1013 and a second thermally conductive plate 1014. In a length direction of the second heat pipe 104, the first thermally conductive plate 1013 and the second thermally conductive plate 1014 may be disposed in parallel, the first thermally conductive plate 1013 is close to the first cooling fan 302, and the second thermally conductive plate 1014 is close to the second cooling fan 303. It may be understood that the first cooling fan 302 and the first fin 1051 corresponding to the first cooling fan 302 are disposed on a side that is of the first thermally conductive plate 1013 and that is far away from the second thermally conductive plate 1014, and the first condensing portion 10411 of the second heat pipe 104 covers the first fin 1051. The second cooling fan 303 and the second fin 1052 corresponding to the second cooling fan 303 are disposed on a side that is of the second thermally conductive plate 1014 and that is far away from the first thermally conductive plate 1013, and the second condensing portion 10412 of the second heat pipe 104 covers the second fin 1052.

In some embodiments, the first thermally conductive plate 1013 and the second thermally conductive plate 1014 may flexibly cover different heat sources 200, to facilitate layout of the heat sources 200. Heat of some heat sources 200 may be absorbed by the first thermally conductive plate 1013, and heat of the other heat sources 200 may be absorbed by the second thermally conductive plate 1014.

In this embodiment of this application, the first thermally conductive plate 1013 and the second thermally conductive plate 1014 are of plate-like structures. Shapes and sizes of the first thermally conductive plate 1013 and the second thermally conductive plate 1014 may be the same or different. A specific shape and size may be determined based on actual layout and a heat dissipation requirement. This is not specifically limited in this embodiment of this application. Affected by component layout, each of the first thermally conductive plate 1013 and the second thermally conductive plate 1014 may be disposed to include a plurality of flat plate structures, and there may be a height difference between the plurality of flat plate structures. This is not specifically limited in this embodiment of this application.

It should be additionally noted that in this embodiment of this application, the thermally conductive plate 101 is not limited to including the first thermally conductive plate 1013 and the second thermally conductive plate 1014, and a manner of arranging the first thermally conductive plate 1013 and the second thermally conductive plate 1014 is not limited to parallel arrangement in the length direction of the second heat pipe 104, and may be determined based on an actual layout status. This is not specifically limited in this embodiment of this application.

Still referring to FIG. 7, the heat dissipation system provided in this embodiment of this application may include a first bridge 401 and a second bridge 402. A first end of the first bridge 401 may be connected to a housing of the first cooling fan 302, and a second end of the first bridge 401 may lap over the first thermally conductive plate 1013. In this way, the first bridge 401 may perform heat transfer between the first thermally conductive plate 1013 and the first cooling fan 302. Heat on the first thermally conductive plate 1013 may be transferred to the housing of the first cooling fan 302 through the first bridge 401, and then the heat on the housing of the first cooling fan 302 may be dissipated to the external environment by using a cold air flow.

A first end of the second bridge 402 may be connected to a housing of the second cooling fan 303, and a second end of the second bridge 402 may lap over the second thermally conductive plate 1014. In this way, the second bridge 402 may perform heat transfer between the second thermally conductive plate 1014. Heat on the second thermally conductive plate 1014 may be transferred to the housing of the second cooling fan 303 through the second bridge 402, and then the heat on the housing of the second cooling fan 303 may be dissipated to the external environment by using a cold air flow.

In some implementations, the first bridge 401 and the first cooling fan 302 may be of an integral structure, and a die casting process may be used, so that the first bridge 401 is integrally formed on the housing of the first cooling fan 302. The second bridge 402 and the second cooling fan 303 may also be of an integral structure, and a die casting process may be used, so that the second bridge 402 is integrally formed on the housing of the second cooling fan 303.

Affected by component layout, shapes, lengths, and the like of the first bridge 401 and the second bridge 402 may be the same or different. This is not specifically limited in this embodiment of this application.

Still referring to FIG. 7, the thermally conductive assembly 100 further includes a first heat pipe 102. The first heat pipe 102 may be bonded to the first thermally conductive plate 1013 and the second thermally conductive plate 1014, and may be specifically bonded to side surfaces that are of the first thermally conductive plate 1013 and the second thermally conductive plate 1014 and that are far away from the heat source 200. It may be learned that the first heat pipe 102 may be disposed across the first thermally conductive plate 1013 and the second thermally conductive plate 1014.

One end of the first heat pipe 102 may extend between the first thermally conductive plate 1013 and the first bridge 401. In this way, the first heat pipe 102 may absorb heat from the first thermally conductive plate 1013, and transfer the heat to the first bridge 401, and further may transfer the heat to the housing of the first cooling fan 302 through the first bridge 401. The first heat pipe 102 has an excellent heat-conducting property. Therefore, the first heat pipe 102 may quickly perform heat transfer between the first bridge 401 and the first thermally conductive plate 1013, to improve heat transfer efficiency between the first bridge 401 and the first thermally conductive plate 1013. Further, heat accumulated on the first thermally conductive plate 1013 can be quickly transferred to the outside, and heat dissipation efficiency is high.

Still referring to FIG. 7, the other end of the first heat pipe 102 may extend between the second thermally conductive plate 1014 and the second bridge 402. In this way, the second heat pipe 104 may absorb heat from the second thermally conductive plate 1014, and transfer the heat to the second bridge 402, and further may transfer the heat to the housing of the second cooling fan 303 through the second bridge 402. The first heat pipe 102 has an excellent heat-conducting property. Therefore, the first heat pipe 102 may also quickly perform heat transfer between the second bridge 402 and the second thermally conductive plate 1014, to improve heat transfer efficiency between the second bridge 402 and the second thermally conductive plate 1014. Further, heat accumulated on the second thermally conductive plate 1014 can be quickly transferred to the outside, and heat dissipation efficiency is high.

In some implementations, the second heat pipe 104 may be welded to the first thermally conductive plate 1013 and the second thermally conductive plate 1014. In this way, thermal resistance between the second heat pipe 104 and each of the first thermally conductive plate 1013 and the second thermally conductive plate 1014 may be reduced, and the second heat pipe 104 may be securely fastened to the first thermally conductive plate 1013 and the second thermally conductive plate 1014.

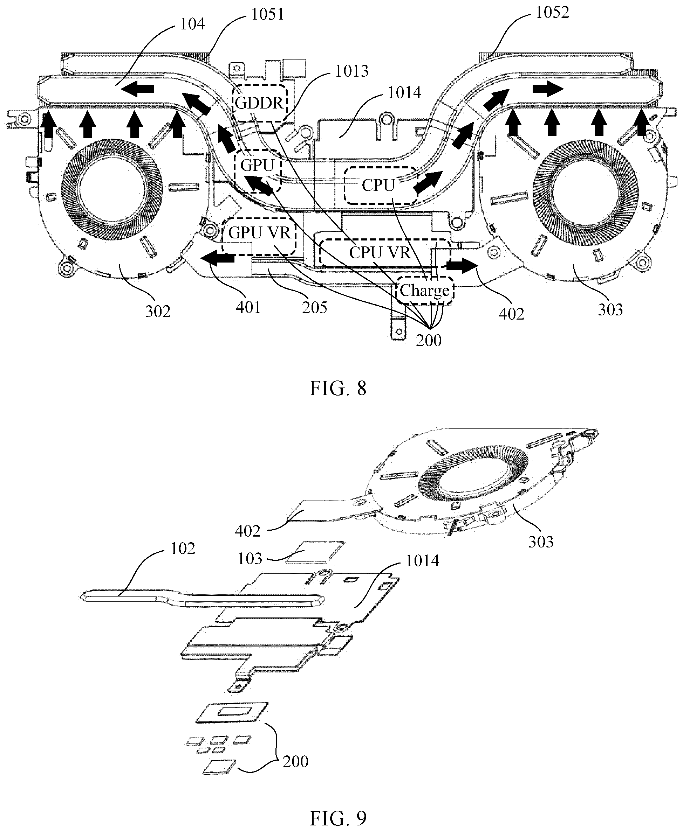

FIG. 8 is a schematic diagram of heat transfer in the heat dissipation system shown in FIG. 7. The heat source 200 in FIG. 8 is merely shown as an example in a form of a dashed box, and does not represent a real structure of the heat source 200.

As shown in FIG. 8, in this embodiment of this application, to transfer the heat on the first thermally conductive plate 1013 and the heat on the second thermally conductive plate 1014 to the external environment, two paths are provided.

In a first path, the first heat pipe 102 absorbs heat from the first thermally conductive plate 1013, and transfers the heat to the first fin 1051. Then, the first cooling fan 302 may rotate and form a cold air flow that directly blows to the first fin 1051, to dissipate the heat on the first fin 1051 to the external environment. The first heat pipe 102 may further absorb heat from the second thermally conductive plate 1014, and transfer the heat to the second fin 1052. Then, the second cooling fan 303 may rotate and form a cold air flow that directly blows the second fin 1052, to dissipate the heat on the second fin 1052 to the external environment.

In a second path, the first bridge 401 transfers the heat on the first thermally conductive plate 1013 to the housing of the first cooling fan 302. Then, as the cold air flow flows inside the first cooling fan 302, the cold air flow may dissipate the heat on the housing of the first cooling fan 302 to the external environment through the first fin 1051. The second bridge 402 transfers the heat on the second thermally conductive plate 1014 to the housing of the second cooling fan 303. Then, as the cold air flow flows inside the second cooling fan 303, the cold air flow may dissipate the heat on the housing of the second cooling fan 303 to the external environment through the second fin 1052. FIG. 9 is a diagram of a position relationship between a second bridge, a second thermally conductive plate, and a first heat pipe according to an embodiment of this application.

As shown in FIG. 8 and FIG. 9, the second end of the second bridge 402 may be close to an edge of the second thermally conductive plate 1014, and the first heat pipe 102 may be located on the edge of the second thermally conductive plate 1014. In addition, an edge of the first thermally conductive plate 1013 is far away from the second heat pipe 104. In this way, a position that is of the second thermally conductive plate 1014 and at which heat is transferred to the outside is dispersedly distributed on the second thermally conductive plate 1014, so that temperature distribution of the second thermally conductive plate 1014 can be more balanced, and local temperature overheating of the electronic device can be avoided, to improve user experience. The first end of the second bridge 402 is fastened to the housing of the second cooling fan 303, and is fastened to a position close to the edge of the second thermally conductive plate 1014. In this way, a heat transfer distance between the second thermally conductive plate 1014 and the second cooling fan 303 may be shortened, so that the heat can be quickly transferred from the second thermally conductive plate 1014 to the housing of the second cooling fan 303, to avoid a case in which working performance of the heat source 200 is affected due to excessive heat accumulation on the second thermally conductive plate 1014.

In an actual layout process, an extension direction of the first heat pipe 102 on the second thermally conductive plate 1014 may follow a layout change of the heat source 200, and is not limited to a case in which the first heat pipe 102 is flush with the edge of the second thermally conductive plate 1014. A side edge that is of the second thermally conductive plate 1014 and that is far away from the second heat pipe 104 may protrude from the first heat pipe 102.

For another position relationship between the first bridge 401, the first thermally conductive plate 1013, and the first heat pipe 102, refer to the foregoing description content of the positions of the second bridge 402, the second thermally conductive plate 1014, and the first heat pipe 102. Details are not described herein.

Still referring to FIG. 7, the thermally conductive assembly 100 further includes a plurality of first thermally conductive pads 103. The first thermally conductive pad 103 may be crimped between the first bridge 401 and each of the first thermally conductive plate 1013 and the first heat pipe 102, and the first thermally conductive pad 103 may be crimped between the second bridge 402 and each of the second thermally conductive plate 1014 and the first heat pipe 102. In this way, heat transfer efficiency may be improved.

The following describes a heat conduction capability of the first bridge 401 and the second bridge 402 by using an example.

Based on a heat conduction theory formula, a heat transfer rate at which heat is transferred between the first thermally conductive plate 1013 and the first bridge 401 is as follows:

$$Q1 = (K \cdot S \cdot \Delta T)/L \qquad \text{formula 1,}$$

where

Q1 is the heat transfer rate at which heat is transferred between the first thermally conductive plate 1013 and the first bridge 401, K is thermal conductivity of the first thermally conductive pad 103, S is a contact area between the first bridge 401 and the first thermally conductive plate 1013, $\Delta T$ is a temperature difference between the first bridge 401 and the first thermally conductive plate 1013, and L is a thickness of the first thermally conductive pad 103. For example, a length and a width of each of the first bridge 401 and the second bridge 402 are approximately 10 mm*10 mm, a thickness existing after the first thermally conductive pad 103 is compressed is approximately 0.25 mm, the thermal conductivity of the first thermally conductive pad 103 is approximately 4W/(*°C), the temperature difference between the first bridge 401 and the first thermally conductive plate 1013 is approximately 5°C, and a temperature difference between the second bridge 402 and the second thermally conductive plate 1014 is also approximately 5°C. In this case, based on the formula 1, it may be calculated that the heat transfer rate at which heat is transferred between the first thermally conductive plate 1013 and the first bridge 401 is Q1=4*0.1*5/0.25=8 W. Correspondingly, a heat transfer rate at which heat is transferred between the second thermally conductive plate 1014 and the second bridge 402 is Q2=8 W. It may be learned that a heat transfer rate at which heat is transferred between the bridge 400 structure and the thermally conductive plate 101 is Q=Q1+Q2=16 W.

In conclusion, the bridge 400 structure is added to the heat dissipation system provided in this embodiment of this application, so that a heat transfer rate of the heat dissipation system is increased by at least 16 W. In this way, efficiency of heat dissipation for the heat source 200 may be improved, so that a temperature of the heat source 200 can be maintained at a relatively low value, to reduce a heat generation loss during working of the heat source 200, and improve working power of the heat source 200.

In some embodiments, the heat dissipation system provided in this embodiment of this application may be applied to a personal computer such as a notebook computer. A specific process in which the heat dissipation system dissipates heat for the notebook computer is described below in detail with reference to the accompanying drawings.

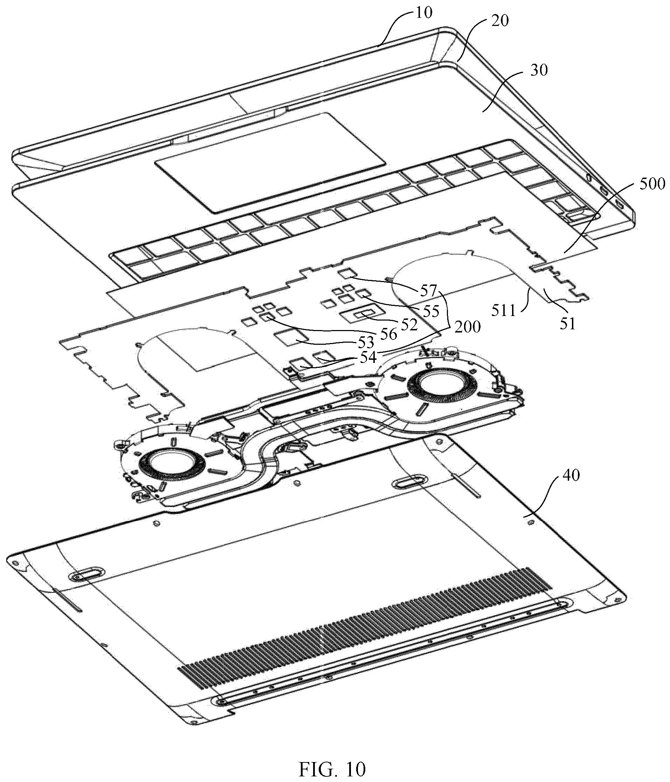

FIG. 10 is a schematic exploded view of a notebook computer that includes a heat dissipation system according to an embodiment of this application.

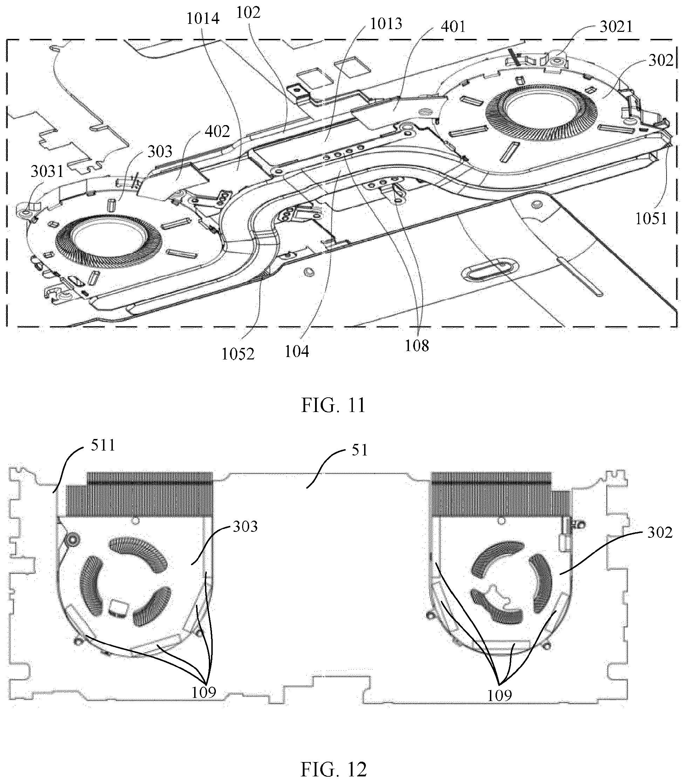

FIG. 11 is a partially enlarged view of FIG. 10.

As shown in FIG. 10 and FIG. 11, the notebook computer includes a rear screen cover (A housing) 10, a front screen frame (B housing) 20, and a screen assembly located between the rear screen cover 10 and the front screen frame 20, and further includes an upper host cover (C housing) 30, a keyboard located on the upper host cover 30, and a lower host cover (D housing) 40. A host board 51 is disposed between the upper host cover 30 and the lower host cover 40. The host board 51 may be a printed circuit board (printed circuit board, PCB), and is laid on a back surface of the keyboard. A main circuit system, for example, a BIOS chip, an I/O control chip, a key and panel control switch interface, an indicator light connector, an expansion slot, direct current power supply connectors for a mainboard and an inserted card, and another element, that forms a computer is arranged on the host board 51. Some heat generation components, for example, a CPU 52, a GPU 53, and a GDDR 54, may be further included between the upper host cover 30 and the lower host cover 40. The heat generation component may further include a capacitor, a MOS transistor, an inductor coil, or the like configured for the CPU. In this embodiment of this application, these components may be collectively referred to as a CPU VR 55. The heat generation component may further include a capacitor, a MOS transistor, an inductor coil, or the like configured for the GPU. In this embodiment of this application, these components may be collectively referred to as a GPU VR 56. The heat generation component may further include any component that generates heat when an electronic device is charged or the like. In this embodiment of this application, the component is referred to as a Charge 57. Further, the CPU 52, the GPU 53, the GDDR 54, the CPU VR 55, the GPU VR 56, and the Charge 57 may be arranged on the host board 51. A specific distribution position of each component may be determined based on an actual requirement. This is not specifically limited in this embodiment of this application. It may be understood that the CPU 52, the GPU 53, the GDDR 54, the CPU VR 55, the GPU VR 56, and the Charge 57 are the heat sources 200 described in the embodiments of this application.

In this embodiment of this application, the first thermally conductive plate 1013 covers the GPU 53, the GDDR 54, and the GPU VR 56, and the second thermally conductive plate 1014 covers the CPU 52, the CPU VR 55, and the Charge 57. Further, the first heat pipe 102 and the second heat pipe 104 are bonded to side surfaces that are of the first thermally conductive plate 1013 and the second thermally conductive plate 1014 and that are far away from the CPU 52.

The CPU 52 and the GPU 53 are components that are relatively obvious for heat generation. Therefore, in this embodiment of this application, an orthographic projection of the second heat pipe 104 in a thickness direction of the heat source 200 may cover the CPU 52 and the GPU 53. In this way, the second heat pipe 104 may quickly dissipate heat for the CPU 52 and the GPU 53, so that the CPU 52 and the GPU 53 can maintain high-performance running. An orthographic projection of the first heat pipe 102 in a thickness direction of the CPU 52 may cover or partially cover the CPU VR 55, the GPU VR 56, and the Charge 57. In this way, a speed of dissipating heat by the second heat pipe 104 for the CPU VR 55, the GPU VR 56, and the Charge 57 may be increased, to quickly balance heat generated when the CPU VR 55, the GPU VR 56, and the Charge 57 work.

In actual application, heat generated by the CPU 52, the GPU 53, the GDDR 54, the CPU VR 55, the GPU VR 56, and the Charge 57 may be absorbed by the first thermally conductive plate 1013 and the second thermally conductive plate 1014. Then, the heat on the first thermally conductive plate 1013 may be transferred to the first fin 1051 through the second heat pipe 104. Further, the heat on the first fin 1051 may be blown to the outside of the notebook computer by the cold air flow generated by the first cooling fan 302. The heat on the second thermally conductive plate 1014 may be transferred to the second fin 1052 through the second heat pipe 104. Further, the heat on the second fin 1052 may be blown to the outside of the notebook computer by the cold air flow generated by the second cooling fan 303. Further, the heat on the first thermally conductive plate 1013 may alternatively be transferred to the housing of the first cooling fan 302 through the first bridge 401, and then the heat may be dissipated to the outside of the notebook computer by using the cold air flow formed by the first cooling fan 302. The heat on the second thermally conductive plate 1014 may alternatively be transferred to the housing of the second cooling fan 303 through the second bridge 402, and then the heat may be dissipated to the outside of the notebook computer by using the cold air flow formed by the second cooling fan 303. It may be learned that the heat dissipation system provided in this embodiment of this application may dissipate heat for the notebook computer, and heat dissipation efficiency is high. This can improve performance of the notebook computer and improve user experience.

Still referring to FIG. 10 and FIG. 11, the heat dissipation system provided in this embodiment of this application may further include a plurality of elastic sheets 108. One end of the elastic sheet 108 may be fastened to the first thermally conductive plate 1013 or the second thermally conductive plate 1014, and the other end is fastened to the host board 51. In this way, the first thermally conductive plate 1013 or the second thermally conductive plate 1014 may be pressed onto the heat source 200. Further, thermal resistance between the first thermally conductive plate 1013 or the second thermally conductive plate 1014 and the heat source 200 may be reduced, and movement of the first thermally conductive plate 1013 or the second thermally conductive plate 1014 may be avoided.

Still referring to FIG. 10 and FIG. 11, an accommodation hole 511 may be disposed on the host board 51, and the first cooling fan 302 and the second cooling fan 303 are located in the accommodation hole 511.

It may be understood that in the notebook computer, there is a vent hole used for air intake and air exhaust of the cooling fan 300.

In some implementations, the heat source 200 may transfer the heat generated by the heat source 200 to a component in direct contact or indirect contact with the heat source 200. The component may be referred to as a heat receiving part 500. For example, if the heat source 200 transfers some heat to the host board 51, a part located on a side that is of the host board 51 and that is far away from the heat source 200 becomes a heat receiving part 500. In actual application, the heat receiving part 500 is usually a keyboard iron part. In this embodiment of this application, the cooling fan 300 may abut against the heat receiving part 500, or there is a small gap of approximately 1 mm between the cooling fan 300 and the heat receiving part 500.

FIG. 12 is a schematic diagram of a position of a third thermally conductive pad according to an embodiment of this application.

As shown in FIG. 10 to FIG. 12, the thermally conductive assembly 100 may further include a third thermally conductive pad 109, and the third thermally conductive pad 109 is crimped between the cooling fan 300 and the heat receiving part 500. In this way, contact thermal resistance between the heat receiving part 500 and the cooling fan 300 may be reduced, to improve heat transfer efficiency.

The third thermally conductive pad 109 may be, for example, silicone rubber, a glass fiber, or a polyester substrate. When being subjected to pressure, the third thermally conductive pad 109 may be compressed and has a good heat-conducting property. Therefore, the third thermally conductive pad 109 may be used to reduce contact thermal resistance between the cooling fan 300 and the heat receiving part 500, to improve heat transfer efficiency.

In this way, heat on the heat receiving part 500 may be absorbed by the housing of the first cooling fan 302 and the housing of the second cooling fan 303. Then, the heat on the housing of the first cooling fan 302 and the housing of the second cooling fan 303 may be dissipated to the external environment by using the cold air flow. It may be learned that in this embodiment of this application, heat may be dissipated for the heat receiving part 500. Further, transfer of the heat on the heat receiving part 500 to the C housing 30 may be avoided, and a surface temperature of the C housing 30 can be reduced, to avoid a problem that user experience is affected due to an excessively high surface temperature of the C housing 30.

Still referring to FIG. 12, some third thermally conductive pads 109 may be disposed on an edge of the first cooling fan 302, and the third thermally conductive pads 109 may be exposed from the accommodation hole 511; and some third thermally conductive pads 109 may be disposed on an edge of the second cooling fan 303, and the third thermally conductive pads 109 may be exposed from the accommodation hole 511. A quantity of third thermally conductive pads 109 is not limited in this embodiment of this application. A specific quantity may be determined based on an actual situation.

Still referring to FIG. 11, a plurality of first screw seats 3021 may be disposed on a side surface of the first cooling fan 302, and a through hole is disposed on the first screw seat 3021 in the thickness direction of the heat source 200. In actual application, a screw may penetrate through the through hole from a side that is of the first cooling fan 302 and that is far away from the heat receiving part 500, and then be threaded with the heat receiving part 500. The heat receiving part 500 herein may be a keyboard iron part of the notebook computer. In this way, the first cooling fan 302 may be locked onto the heat receiving part. In addition, the screw may exert force in a direction close to the heat receiving part 500 on the first cooling fan 302. In this way, the first bridge 401 may be tightly bonded to the first thermally conductive plate 1013 and the first heat pipe 102, to reduce thermal resistance between the first bridge 401 and each of the first thermally conductive plate 1013 and the first heat pipe 102 as much as possible.

Correspondingly, a plurality of second screw seats 3031 may be disposed on a side surface of the second cooling fan 303, and a through hole is disposed on the second screw seat 3031 in the thickness direction of the heat source 200. In actual application, a screw may penetrate through the through hole from a side that is of the second cooling fan 303 and that is far away from the heat receiving part 500, and then be threaded with the heat receiving part 500. The heat receiving part 500 herein may be a keyboard iron part of the notebook computer. In this way, the second cooling fan 303 may be locked onto the heat receiving part 500. In addition, the screw may exert force in a direction close to the heat receiving part 500 on the second cooling fan 303. In this way, the second bridge 402 may be tightly bonded to the second thermally conductive plate 1014 and the heat receiving part 500, to reduce thermal resistance between the second bridge 402 and each of the second thermally conductive plate 1014 and the first heat pipe 102 as much as possible.

In some implementations, a quantity of first bridges 401 between the first cooling fan 302 and the first thermally conductive plate 1013 is not limited to one. To quickly dissipate the heat on the first thermally conductive plate 1013 to the external environment and avoid heat accumulation on the first thermally conductive plate 1013, the quantity of first bridges 401 may be increased. For example, there may be two first bridges 401, and the two first bridges 401 may be disposed at different positions of the first thermally conductive plate 1013. This is not specifically limited in this embodiment of this application. Correspondingly, a quantity of second bridges 402 between the second cooling fan 303 and the second thermally conductive plate 1014 is not limited to one. To quickly dissipate the heat on the second thermally conductive plate 1014 to the external environment and avoid heat accumulation on the second thermally conductive plate 1014, the quantity of second bridges 402 may be increased. For example, there may be two second bridges 402, and the two second bridges 402 may be disposed at different positions of the second thermally conductive plate 1014. This is not specifically limited in this embodiment of this application.

It should be noted that in this embodiment of this application, heat transfer performed by using the second heat pipe 104 may be considered as heat transfer performed on a plane. Further, heat transfer is performed between the bridge 400 and each of the thermally conductive plate 101 and the first heat pipe 102, and heat is transferred from a plane on which the thermally conductive plate 101 and the first heat pipe 102 are located to a plane on which the bridge 400 is located, to implement spatial heat transfer. Further, in this embodiment of this application, transfer may also be performed between a plane on which the heat receiving part 500 is located and a plane on which the cooling fan 400 is located. A three-dimensional structure of the cooling fan 400 may be applied to a heat dissipation process, to implement spatial heat transfer. It may be learned that in this embodiment of this application, three-dimensional heat dissipation may be performed by using a temperature difference that exists in space between parts of the electronic device, and a heat dissipation effect is significant.

In this embodiment of this application, the thermally conductive assembly 100 may be designed, so that the thermally conductive assembly 100 forms a plurality of parts far away from the heat source 200. Further, cooling fans 300 may be correspondingly disposed for all of the plurality of parts that are of the thermally conductive assembly 100 and that are far away from the heat source 200, bridges 400 are disposed for all of the plurality of cooling fans 300, and all of the bridges 400 lap over the thermally conductive assembly 100. **In** this way, efficiency of heat dissipation for the thermally conductive assembly 100 may be improved, to avoid a case in which heat is accumulated on the thermally conductive assembly 100 and cannot be dissipated.

**In** some embodiments, a heat pipe group may be provided. The heat pipe group includes a plurality of second heat pipes 104. The plurality of second heat pipes 104 may extend to an outer side of the thermally conductive plate 101 in different directions, to form a plurality of condensing portions 1041, and each condensing portion 1041 may be correspondingly connected to a fin 105. **In** this case, the plurality of condensing portions 1041 are equivalent to a plurality of parts that are of the thermally conductive assembly 100 and that are far away from the heat source 200.

For example, the plurality of second heat pipes 104 may extend in three directions, to form three condensing portions 1041. Further, each condensing portion 1041 may be correspondingly connected to a fin 105, and a cooling fan 300 is correspondingly disposed for each condensing portion 1041. An air outlet of the cooling fan 300 faces the condensing portion 1041 corresponding to the cooling fan 300, and faces the fin 105 connected to the condensing portion 1041 corresponding to the cooling fan 300. Further, a bridge 400 may be disposed for each cooling fan 300, and bridges 400 corresponding to the three cooling fans 300 may separately lap over the thermally conductive plate 101. The heat pipe group may further extend to form more than three condensing portions 1041. Details are not described herein.

In some implementations, the first heat pipe 102 and the second heat pipe 104 provided in this embodiment of this application further include a capillary porous material, an insulation portion, and the like. This is not specifically limited in this embodiment of this application.

In some implementations, each of the first heat pipe 102 and the second heat pipe 104 may be replaced with a vapor chamber (Vapor-Chamber, VC) plate. A specific shape of the VC plate may be determined based on an actual situation. This is not specifically limited in this embodiment of this application.

In some implementations, a Mylar sheet may be further disposed on a side surface that is of the thermally conductive plate 101 and that is close to the heat source 200, so that the thermally conductive plate 101 is electrically insulated from another component, to avoid a case in which normal running of the electronic device is affected because the thermally conductive plate 101 is electrically conductive.

In some implementations, when an orthographic projection of the screw seat on the cooling fan 300 in the thickness direction of the heat source 200 is located on the bridge 400, the bridge 400 may be provided with a through hole corresponding to the screw seat, so that the cooling fan 300 can be mounted normally. Whether the orthographic projection of the screw seat in the thickness direction of the heat source 200 is located on the bridge 400 may be determined based on an actual layout status. This is not specifically limited in this embodiment of this application.

An embodiment of this application further provides an electronic device, and the heat dissipation system provided in the foregoing embodiments is configured for the electronic device. In the electronic device, a heat source 200 is, for example, a CPU, a GPU, or a GDDR of the electronic device, may be a capacitor, a MOS transistor, an inductor coil, or the like configured for a CPU or a GPU, or may be any component that generates heat when the electronic device is charged or the like. The electronic device may be, for example, a notebook computer. This is not specifically limited in this embodiment of this application. After the heat dissipation system is configured, heat dissipation efficiency of the heat source 200 of the electronic device is improved, to avoid abnormal heat generation or frequency reduction of the heat source 200 that is caused due to a poor heat dissipation effect. This can improve working performance of the heat source 200 and improve user experience.

The objectives, technical solutions, and beneficial effects of the embodiments of this application are further described in detail in the foregoing specific implementations. It should be understood that the foregoing descriptions are merely specific implementations of the embodiments of this application, but are not intended to limit the scope of the embodiments of this application. Any modification, equivalent replacement, improvement, or the like made based on the technical solutions of the embodiments of this application shall fall within the scope of the embodiments of this application.

**Claims**

1. A heat dissipation system, comprising:

    a thermally conductive assembly (100), wherein the thermally conductive assembly (100) comprises a thermally conductive plate (101), and the thermally conductive plate (101) covers a surface of a heat source (200);
    a cooling fan (300), wherein an air outlet of the cooling fan (300) faces the thermally conductive assembly (100); and
    a bridge (400), wherein a first end of the bridge (400) is connected to a housing of the cooling fan (300), and a second end of the bridge (400) is connected to the thermally conductive plate (101), wherein
    both the housing of the cooling fan (300) and the bridge (400) are made of metal materials; and
    the thermally conductive assembly (100) further comprises a first heat pipe (102), the first heat pipe (102) is bonded to the thermally conductive plate (101), and one end of the first heat pipe (102) is located between the thermally conductive plate (101) and the bridge (400).

2. The heat dissipation system according to claim 1, wherein
a thermally conductive medium is filled between the thermally conductive assembly (100) and the heat source (200).

3. The heat dissipation system according to claim 1 or 2, wherein
the cooling fan (300) abuts against a part that is of the thermally conductive assembly (100) and that is far away from the heat source (200).

4. The heat dissipation system according to any one of claims 1 to 3, wherein
the thermally conductive medium is filled between the thermally conductive plate (101) and the heat source (200).

5. The heat dissipation system according to any one of claims 2 to 4, wherein

the thermally conductive assembly (100) further comprises a first thermally conductive pad (103); and
the first thermally conductive pad (103) is crimped between the bridge (400) and each of the thermally conductive plate (101) and the first heat pipe (102).

6. The heat dissipation system according to claim 5, wherein

the thermally conductive plate (101) comprises a first flat plate (1011) and a second flat plate (1012) that are connected to each other;
both the first flat plate (1011) and the second flat plate (1012) cover the surface of the heat source (200), and the thermally conductive medium is filled between the heat source (200) and each of the first flat plate (1011) and the second flat plate (1012);
there is a height difference between the first flat plate (1011) and the second flat plate (1012); and
the first heat pipe (102) is located on a side surface that is of the first flat plate (1011) and that is far away from the heat source (200), and a side surface that is of the first heat pipe (102) and that is far away from the heat source (200) and a side surface that is of the second flat plate (1012) and that is far away from the heat source (200) are on a same plane.

7. The heat dissipation system according to claim 5, wherein
the thermally conductive assembly (100) further comprises:

at least one second heat pipe (104) that is bonded to the thermally conductive plate (101), wherein the second heat pipe (104) extends outward from the thermally conductive plate (101) in at least one direction, to form at least one condensing portion (1041) far away from the heat source (200); and
a fin (105) that is distributed in each condensing portion (1041) and that is connected to a pipe wall of the condensing portion (1041); and
at least one cooling fan (300), wherein
the at least one cooling fan (300) is disposed in a one-to-one correspondence with the at least one condensing portion (1041), and an air outlet of each cooling fan (300) faces the condensing portion (1041) corresponding to the cooling fan (300), and faces the fin (105) connected to the condensing portion (1041) corresponding to the cooling fan (300).

8. The heat dissipation system according to claim 7, wherein
when there are a plurality of second heat pipes (104), the plurality of second heat pipes (104) are disposed in parallel on the thermally conductive plate (101).

9. The heat dissipation system according to claim 4, wherein

the thermally conductive medium comprises a second thermally conductive pad (106), and the second thermally conductive pad (106) is crimped between the thermally conductive plate (101) and the heat source (200); and/or
the thermally conductive medium comprises thermally conductive silicone (107), and the thermally conductive silicone (107) is filled between the thermally conductive plate (101) and the heat source (200).

10. The heat dissipation system according to claim 4, wherein

the thermally conductive assembly (100) further comprises an elastic sheet (108); and
one end of the elastic sheet (108) is fastened to the thermally conductive plate (101), and the other end is fastened to a printed circuit board on which the heat source (200) is located, to press the thermally conductive plate (101) onto the heat source (200).

11. The heat dissipation system according to claim 1, wherein
the housing of the cooling fan (300) abuts against a heat receiving part (500), and heat on the heat receiving part (500) is transferred by the heat source (200).

12. The heat dissipation system according to claim 11, wherein
the thermally conductive assembly (100) further comprises a third thermally conductive pad (109), and the third thermally conductive pad (109) is crimped between the cooling fan (300) and the heat receiving part (500).

13. The heat dissipation system according to claim 1, wherein
the bridge (400) and the cooling fan (300) are of an integral structure.

14. An electronic device, comprising the heat dissipation system according to any one of claims 1-13.


**Patentansprüche**

1. Ein Wärmeableitungssystem, umfassend:

   eine wärmeleitende Baugruppe (100), wobei die wärmeleitende Baugruppe (100) eine wärmeleitende Platte (101) umfasst und die wärmeleitende Platte (101) eine Oberfläche einer Wärmequelle (200) abdeckt;
   einen Kühlventilator (300), wobei ein Luftauslass des Kühlventilators (300) auf die wärmeleitende Baugruppe (100) gerichtet ist; und
   eine Brücke (400), wobei ein erstes Ende der Brücke (400) mit einem Gehäuse des Kühlventilators (300) verbunden ist und ein zweites Ende der Brücke (400) mit der wärmeleitenden Platte (101) verbunden ist, wobei sowohl das Gehäuse des Kühlventilators (300) als auch die Brücke (400) aus Metallmaterialien bestehen; und
   die wärmeleitende Baugruppe (100) ferner ein erstes Wärmeleitrohr (102) umfasst, wobei das erste Wärmeleitrohr (102) mit der wärmeleitenden Platte (101) verbunden ist und ein Ende des ersten Wärmeleitrohrs (102) sich zwischen der wärmeleitenden Platte (101) und der Brücke (400) befindet.

2. Das Wärmeableitungssystem nach Anspruch 1, wobei
zwischen der wärmeleitenden Baugruppe (100) und der Wärmequelle (200) ein wärmeleitendes Medium eingefüllt ist.

3. Das Wärmeableitungssystem nach Anspruch 1 oder 2, wobei
der Kühlventilator (300) an einem Teil der wärmeleitenden Baugruppe (100) anliegt, der von der Wärmequelle (200) entfernt ist.

4. Das Wärmeableitungssystem nach einem der Ansprüche 1 bis 3, wobei
zwischen der wärmeleitenden Platte (101) und der Wärmequelle (200) ein wärmeleitendes Medium eingefüllt ist.

5. Das Wärmeableitungssystem nach einem der Ansprüche 2 bis 4, wobei

   die wärmeleitende Baugruppe (100) ferner ein erstes wärmeleitendes Polster (103) umfasst; und
   das erste wärmeleitende Polster (103) zwischen der Brücke (400) und jeweils der wärmeleitenden Platte (101) sowie dem ersten Wärmeleitrohr (102) geklemmt ist.

6. Das Wärmeableitungssystem nach Anspruch 5, wobei

   die wärmeleitende Platte (101) eine erste Flachplatte (1011) und eine zweite Flachplatte (1012) umfasst, die miteinander verbunden sind;
   sowohl die erste Flachplatte (1011) als auch die zweite Flachplatte (1012) bedecken die Oberfläche der Wärmequelle (200), und zwischen der Wärmequelle (200) und jeweils der ersten Flachplatte (1011) sowie der zweiten Flachplatte (1012) ist ein wärmeleitendes Medium eingefüllt;

zwischen der ersten Flachplatte (1011) und der zweiten Flachplatte (1012) besteht ein Höhenunterschied; und Das erste Wärmerohr (102) befindet sich auf einer Seitenfläche der ersten Flachplatte (1011), die vom Wärmequelle (200) entfernt ist, und eine Seitenfläche des ersten Wärmerohrs (102), die vom Wärmequelle (200) entfernt ist, sowie eine Seitenfläche der zweiten Flachplatte (1012), die ebenfalls vom Wärmequelle (200) entfernt ist, liegen in einer Ebene.

7. Wärmedissipationssystem gemäß Anspruch 5, wobei
Die wärmeleitende Baugruppe (100) umfasst ferner:

Mindestens ein zweites Wärmerohr (104), das an der wärmeleitenden Platte (101) befestigt ist, wobei das zweite Wärmerohr (104) sich von der wärmeleitenden Platte (101) in mindestens eine Richtung nach außen erstreckt, um wenigstens einen Kondensationsabschnitt (1041) zu bilden, der von der Wärmequelle (200) entfernt ist; und Eine Lamelle (105), die in jedem Kondensationsabschnitt (1041) verteilt und mit der Rohrwand des Kondensationsabschnitts (1041) verbunden ist; und
Mindestens ein Kühlventilator (300), wobei der mindestens eine Kühlventilator (300) in direkter Beziehung zu dem mindestens einen Kondensationsabschnitt (1041) angeordnet ist, und ein Luftauslass jedes Kühlventilators (300) dem Kondensationsabschnitt (1041) zugewandt ist, der dem jeweiligen Kühlventilator (300) entspricht, und der Lamelle (105) gegenüberliegt, die mit dem Kondensationsabschnitt (1041) verbunden ist, der dem entsprechenden Kühlventilator (300) zugeordnet ist.

8. Wärmedissipationssystem gemäß Anspruch 7, wobei
Wenn mehrere zweite Wärmerohre (104) vorhanden sind, werden diese parallel auf der wärmeleitenden Platte (101) angeordnet.

9. Wärmedissipationssystem gemäß Anspruch 4, wobei

Das wärmeleitende Medium umfasst ein zweites wärmeleitendes Pad (106), wobei das zweite wärmeleitende Pad (106) zwischen der wärmeleitenden Platte (101) und der Wärmequelle (200) angepresst ist; und/oder
Das wärmeleitende Medium umfasst wärmeleitendes Silikon (107), wobei das wärmeleitende Silikon (107) zwischen der wärmeleitenden Platte (101) und der Wärmequelle (200) eingebracht ist.

10. Wärmedissipationssystem gemäß Anspruch 4, wobei

Die wärmeleitende Baugruppe (100) umfasst ferner ein elastisches Blatt (108); und
Ein Ende des elastischen Blattes (108) ist an der wärmeleitenden Platte (101) befestigt, und das andere Ende ist an einer Leiterplatte befestigt, auf der sich die Wärmequelle (200) befindet, um die wärmeleitende Platte (101) auf die Wärmequelle (200) zu drücken.

11. Wärmedissipationssystem gemäß Anspruch 1, wobei
Das Gehäuse des Lüfters (300) stößt an einen wärmeaufnehmenden Teil (500), und die Wärme des wärmeaufnehmenden Teils (500) wird durch die Wärmequelle (200) übertragen.

12. Das Wärmeableitungssystem gemäß Anspruch 11, wobei
Die wärmeleitende Baugruppe (100) umfasst ferner ein drittes wärmeleitendes Pad (109), und das dritte wärmeleitende Pad (109) ist zwischen dem Lüfter (300) und dem wärmeaufnehmenden Teil (500) eingeklemmt.

13. Das Wärmeableitungssystem gemäß Anspruch 1, wobei
Die Brücke (400) und der Lüfter (300) eine integrale Struktur bilden.

14. Elektronisches Gerät, umfassend das Wärmeableitungssystem nach einem der Ansprüche 1 bis 13.

**Revendications**

1. Un système de dissipation thermique, comprenant :

un ensemble thermiquement conducteur (100), où l'ensemble thermiquement conducteur (100) comprend une plaque thermiquement conductrice (101), et la plaque thermiquement conductrice (101) recouvre une surface d'une source de chaleur (200) ;

un ventilateur de refroidissement (300), dont la sortie d'air du ventilateur de refroidissement (300) fait face à l'ensemble thermiquement conducteur (100) ; et

un pont (400), dont une première extrémité du pont (400) est reliée à un boîtier du ventilateur de refroidissement (300), et une seconde extrémité du pont (400) est reliée à la plaque thermiquement conductrice (101), dans lequel le boîtier du ventilateur de refroidissement (300) et le pont (400) sont tous deux fabriqués en matériaux métalliques ; et

l'ensemble thermiquement conducteur (100) comprend en outre un premier caloduc (102), le premier caloduc (102) est fixé à la plaque thermiquement conductrice (101), et une extrémité du premier caloduc (102) est située entre la plaque thermiquement conductrice (101) et le pont (400).

2. Le système de dissipation thermique selon la revendication 1, dans lequel
un milieu thermiquement conducteur est placé entre l'ensemble thermiquement conducteur (100) et la source de chaleur (200).

3. Le système de dissipation thermique selon la revendication 1 ou 2, dans lequel
le ventilateur de refroidissement (300) est en contact avec une partie de l'ensemble thermiquement conducteur (100) qui est éloignée de la source de chaleur (200).

4. Le système de dissipation thermique selon l'une quelconque des revendications 1 à 3, dans lequel
le milieu thermiquement conducteur est placé entre la plaque thermiquement conductrice (101) et la source de chaleur (200).

5. Le système de dissipation thermique selon l'une quelconque des revendications 2 à 4, dans lequel

l'ensemble thermiquement conducteur (100) comprend en outre un premier pad thermiquement conducteur (103) ; et

le premier pad thermiquement conducteur (103) est comprimé entre le pont (400) et chacun de la plaque thermiquement conductrice (101) et du premier caloduc (102).

6. Le système de dissipation thermique selon la revendication 5, dans lequel

la plaque thermiquement conductrice (101) comprend une première plaque plate (1011) et une seconde plaque plate (1012) qui sont reliées entre elles ;

la première plaque plate (1011) et la seconde plaque plate (1012) recouvrent toutes deux la surface de la source de chaleur (200), et le milieu thermiquement conducteur est placé entre la source de chaleur (200) et chacune de la première plaque plate (1011) et de la seconde plaque plate (1012) ;

il existe une différence de hauteur entre la première plaque plate (1011) et la seconde plaque plate (1012) ; et

le premier caloduc (102) est situé sur une surface latérale de la première plaque plate (1011) qui est éloignée de la source de chaleur (200), et une surface latérale du premier caloduc (102) éloignée de la source de chaleur (200) et une surface latérale de la seconde plaque plate (1012) éloignée de la source de chaleur (200) sont situées sur un même plan.

7. Système de dissipation thermique selon la revendication 5, dans lequel
l'ensemble conducteur thermique (100) comprend en outre :

au moins un second caloduc (104) qui est fixé à la plaque conductrice thermique (101), le second caloduc (104) s'étendant vers l'extérieur de la plaque conductrice thermique (101) dans au moins une direction, pour former au moins une partie de condensation (1041) éloignée de la source de chaleur (200) ; et

une ailettes (105) distribuée dans chaque partie de condensation (1041) et connectée à la paroi du tube de la partie de condensation (1041) ; et

au moins un ventilateur de refroidissement (300), le ou les ventilateurs de refroidissement (300) étant disposés en correspondance individuelle avec la ou les parties de condensation (1041), et une sortie d'air de chaque ventilateur de refroidissement (300) fait face à la partie de condensation (1041) correspondante et à l'ailette (105) connectée à la partie de condensation (1041) correspondante du ventilateur de refroidissement (300).

8. Système de dissipation thermique selon la revendication 7, dans lequel
lorsqu'il y a une pluralité de seconds caloducs (104), les seconds caloducs (104) sont disposés en parallèle sur la plaque conductrice thermique (101).

9.  Système de dissipation thermique selon la revendication 4, dans lequel

    le milieu conducteur thermique comprend un second coussin conducteur thermique (106), et le second coussin conducteur thermique (106) est serti entre la plaque conductrice thermique (101) et la source de chaleur (200) ; et/ou
    le milieu conducteur thermique comprend de la silicone conductrice thermique (107), et la silicone conductrice thermique (107) est injectée entre la plaque conductrice thermique (101) et la source de chaleur (200).

10. Système de dissipation thermique selon la revendication 4, dans lequel

    l'ensemble conducteur thermique (100) comprend en outre une lame élastique (108) ; et
    une extrémité de la lame élastique (108) est fixée à la plaque conductrice thermique (101), et l'autre extrémité est fixée à une carte de circuit imprimé sur laquelle se trouve la source de chaleur (200), afin de presser la plaque conductrice thermique (101) contre la source de chaleur (200).

11. Système de dissipation thermique selon la revendication 1, dans lequel
    le boîtier du ventilateur de refroidissement (300) est en contact avec une partie réceptrice de chaleur (500), et la chaleur sur la partie réceptrice de chaleur (500) est transférée par la source de chaleur (200).

12. Système de dissipation thermique selon la revendication 11, dans lequel
    l'ensemble thermoconducteur (100) comprend en outre un troisième coussinet thermoconducteur (109), et le troisième coussinet thermoconducteur (109) est serti entre le ventilateur de refroidissement (300) et la partie réceptrice de chaleur (500).

13. Système de dissipation thermique selon la revendication 1, dans lequel
    le pont (400) et le ventilateur de refroidissement (300) présentent une structure intégrale.

14. Un dispositif électronique comprenant le système de dissipation thermique selon l'une quelconque des revendications 1 à 13.

FIG. 1

FIG. 2

FIG. 3

FIG. 4

FIG. 5

FIG. 6

FIG. 7

FIG. 8

FIG. 9

FIG. 10

FIG. 11

FIG. 12

**EP 4 474 947 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310429372
- US 2023069684 A1
- US 2012293958 A1